(19) Europäisches Patentamt
European Patent Office
Office européen des brevets

(11) **EP 2 988 409 A1**

(12) **EUROPEAN PATENT APPLICATION**
published in accordance with Art. 153(4) EPC

(43) Date of publication:
**24.02.2016 Bulletin 2016/08**

(51) Int Cl.:
**H02N 2/00** (2006.01)

(21) Application number: **14782836.2**

(22) Date of filing: **26.03.2014**

(86) International application number:
**PCT/JP2014/058592**

(87) International publication number:
**WO 2014/168008 (16.10.2014 Gazette 2014/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **12.04.2013 JP 2013084222**

(71) Applicant: **Mitsumi Electric Co., Ltd.
Tama-shi, Tokyo 206-8567 (JP)**

(72) Inventors:
• **FURUKAWA, Kenichi
Tama-shi
Tokyo 206-8567 (JP)**
• **NUMAKUNAI, Takayuki
Tama-shi
Tokyo 206-8567 (JP)**

(74) Representative: **Solf, Annkathrin
Patent- und Rechtsanwälte
Dr. Solf & Zapf
Candidplatz 15
81543 München (DE)**

(54) **POWER GENERATION DEVICE**

(57) A power generator 1 includes a magnetostrictive rod 2 through which lines of magnetic force pass in an axial direction thereof, a beam portion 73 having a function of causing stress in the magnetostrictive rod 2, and a coil 3 provided so that the lines of magnetic force pass inside the coil 3 in an axial direction of the coil 3. A space between the magnetostrictive rod 2 and the beam portion 73 at the other end of the magnetostrictive rod 2 is smaller than that at one end of the magnetostrictive rod 2 in a side view of the power generator 1. In such a configuration, a stiffness in a displacement direction of a pair of opposed beams formed from the magnetostrictive rod 2 and the beam portion 73 becomes gradually lower from a proximal end thereof toward a distal end thereof. With such a configuration, when external force is applied to the distal end of the magnetostrictive rod 2, it is possible to smoothly displace the magnetostrictive rod 2 and the beam portion 73 in the displacement direction. Therefore, it is possible to make variability of stress caused in the thickness direction of the magnetostrictive rod 2 small. As a result, it is possible to cause uniform stress in the magnetostrictive rod 2 to thereby improve the power generating efficiency of the power generator 1.

FIG.1

EP 2 988 409 A1

**Description**

**TECHNICAL FIELD**

The present invention relates to a power generator.

**BACKGROUND ART**

In recent years, a power generator which can generate electric power by utilizing variation of magnetic permeability of a magnetostrictive rod formed of a magnetostrictive material has been developed (for example, see patent document 1).

For example, this power generator described in the patent document 1 includes a pair of magnetostrictive rods arranged in parallel with each other, a coupling yoke for coupling the magnetostrictive rods with each other, coils arranged so as to respectively surround the magnetostrictive rods, a permanent magnet for applying a bias magnetic field to the magnetostrictive rods and a back yoke. The pair of magnetostrictive rods serves as a pair of opposed beams (parallel beams). When external force is applied to the coupling yoke in a direction perpendicular to an axial direction of each of the magnetostrictive rods, one of the magnetostrictive rods is deformed so as to be expanded and the other of the magnetostrictive rods is deformed so as to be contracted. At this time, density of lines of magnetic force (magnetic flux density) passing through each magnetostrictive rod (that is density of lines of magnetic force passing through each coil) varies. As a result of this variation of the density of the lines of magnetic force, a voltage is generated in each coil.

From a point of view of improving power generating efficiency in such a power generator, it is preferred that only extension stress is caused in one of the magnetostrictive rods and only contraction stress is caused in the other one of the magnetostrictive rods.

However, by analyzing stress actually caused in each magnetostrictive rod used in the power generator, it has been found that both extension stress and contraction stress are caused in one magnetostrictive rod. In particular, it has been found that in both end portions of each magnetostrictive rod, one of the extension stress and the contraction stress is caused in a side of one surface thereof and the other of the extension stress and the contraction stress is caused in a side of the other surface thereof. Further it has also been found that a difference between the extension stress and the contraction stress caused in the both end portions of each magnetostrictive rod is large. Namely, it has been found that variability of stress caused in a thickness direction of each magnetostrictive rod is large. Therefore, there is a case where it is difficult to cause uniform stress (that is only one of the extension stress and the contraction stress) in one magnetostrictive rod. In such a case, it is not possible to increase an amount of variation of the magnetic flux density in each magnetostrictive rod. As a result, there is a problem in that a sufficient amount of the electric power cannot be obtained.

**RELATED ART DOCUMENT**

**PATENT DOCUMENT**

Patent document 1: WO 2011/158473

**SUMMARY OF THE INVENTION**

**PROBLEM TO BE SOLVED BY THE INVENTION**

The present invention has been made in view of the problem mentioned above. Accordingly, it is an object of the present invention to provide a power generator which can cause uniform stress in a magnetostrictive rod used therein to thereby efficiently generate electric power.

In order to achieve the object described above, the present invention includes the following features (1) to (16).

(1) 1. A power generator comprising:

at least one magnetostrictive rod through which lines of magnetic force pass in an axial direction thereof, the magnetostrictive rod formed of a magnetostrictive material and having one end and the other end;
a beam portion having a function of causing stress in the magnetostrictive rod; and
a coil provided so that the lines of magnetic force pass inside the coil in an axial direction of the coil whereby a voltage is generated due to variation of density of the lines of magnetic force,
wherein the power generator is configured so that the density of the lines of magnetic force varies when the other end of the magnetostrictive rod is relatively displaced toward a direction substantially perpendicular to an axial direction of the magnetostrictive rod with respect to the one end of the magnetostrictive rod to expand or contract the magnetostrictive rod, and

wherein a space between the magnetostrictive rod and the beam portion at the other end of the magnetostrictive rod is smaller than that at the one end of the magnetostrictive rod in a side view of the power generator.

(2) The power generator according to the above (1), wherein an angle between the magnetostrictive rod and the beam portion in a side view of the power generator is in the range of 0.5 to 10°.

(3) The power generator according to the above (1) or (2), wherein the beam portion is formed of a non-magnetic material.

(4) The power generator according to any one of the above (1) to (3), wherein the magnetostrictive rod and the beam portion are arranged so as not to be overlapped with each other in a side view of the power generator.

(5) The power generator according to any one of the above (1) to (4), wherein the at least one magnetostrictive rod comprises two or more magnetostrictive rods arranged in parallel with each other, and

wherein the two or more magnetostrictive rods and the beam portion are arranged so as not to be overlapped with each other in a planar view of the power generator.

(6) The power generator according to the above (5), wherein the beam portion is arranged between the magnetostrictive rods in a planar view of the power generator.

(7) The power generator according to the above (5) or (6), wherein the coil comprises two or more coils provided around the magnetostrictive rods, respectively, and

wherein each coil and the beam portion are arranged so as not to be overlapped with each other in a planar view of the power generator.

(8) The power generator according to any one of the above (1) to (7), wherein each coil includes a bobbin arranged around an outer peripheral portion of the magnetostrictive rod so as to surround the magnetostrictive rod and a wire wound around the bobbin, and

wherein a gap is formed between the magnetostrictive rod and the bobbin on at least a side of the other end of the magnetostrictive rod.

(9) The power generator according to the above (8), wherein a displacement of the other end of each magnetostrictive rod is caused by applying vibration to the magnetostrictive rod, and

wherein the gap is formed so as to have a size so that the bobbin and the magnetostrictive rod do not mutually interfere while the magnetostrictive rod is vibrated.

(10) The power generator according to any one of the above (5) to (9), wherein a total number of the magnetostrictive rods and the beam portion is an odd number.

(11) The power generator according to any one of the above (5) to (10), further comprising at least one permanent magnet arranged so that a magnetization direction thereof is directed to an arrangement direction of the magnetostrictive rods, and

wherein the permanent magnet is arranged at least between the one ends of the magnetostrictive rods or between the other ends of the magnetostrictive rods.

(12) The power generator according to any one of the above (1) to (11), wherein when a spring constant of the beam portion is defined as "A" [N/m], a number of the beam portion is defined as "X" [piece], a spring constant of the magnetostrictive rod is defined as "B" [N/m], and a number of the magnetostrictive rod is defined as "Y" [piece], a value of "A × X" and a value of "B × Y" are substantially equal to each other.

(13) The power generator according to any one of the above (1) to (12), wherein a Young's modulus of a constituent material of the beam portion is in the range of 80 to 200 GPa, and a Young's modulus of the magnetostrictive material is in the range of 30 to 100 GPa.

(14) The power generator according to any one of the above (1) to (13), wherein the beam portion causes extension stress or contraction stress in the magnetostrictive rod in a natural state thereof.

(15) The power generator according to any one of the above (1) to (14), wherein the coil is provided around the magnetostrictive rod.

(16) The power generator according to any one of the above (1) to (15), further comprising at least one permanent magnet arranged so that a magnetization direction thereof is directed to a substantially orthogonal direction with respect to an axial direction of the magnetostrictive rod.

**EFFECT OF THE INVENTION**

According to the present invention, the space between the magnetostrictive rod and the beam portion at the other end of the magnetostrictive rod is smaller than that at the one end of the magnetostrictive rod in a side view of the power generator. In such a configuration, a stiffness in a displacement direction of a pair of opposed beams formed from the magnetostrictive rod and the beam portion becomes gradually lower from a proximal end thereof toward a distal end thereof. With such a configuration, when external force is applied to the distal end of the magnetostrictive rod, it is possible to smoothly displace the magnetostrictive rod and the beam portion in the displacement direction. Therefore, it is possible to make variability of stress caused in the thickness direction of the magnetostrictive rod small. As a result, it is possible to cause uniform stress in the magnetostrictive rod to thereby improve the power generating efficiency of the power generator.

**BRIEF DESCRIPTION OF THE DRAWINGS**

Fig. 1 is a perspective view showing a power generator according to a first embodiment of the present invention.
Fig. 2 is an exploded perspective view showing the power generator shown in Fig. 1.
Fig. 3(a) is a side view showing the power generator shown in Fig. 1.
Fig. 3(b) is a side view showing the power generator shown in Fig. 3(a) from which a coil is removed from each magnetostrictive rod.
Fig. 4 is a planar view showing the power generator shown in Fig. 1.
Fig. 5 is a front view showing the power generator shown in Fig. 1.
Fig. 6(a) is a right side view showing a state in which the power generator (the coil is omitted) shown in Fig. 1 is fixedly attached to a vibrating body.
Fig. 6(b) is a right side view showing a state in which external force is applied to a distal end of the power generator shown in Fig. 6(a) in a downward direction thereof.
Fig. 7 is a side view schematically showing a state in which a rod (a beam) is fixed to a case at a proximal end thereof and external force is applied to a distal end of the rod in a downward direction thereof.
Fig. 8 is a side view schematically showing a state in which a pair of opposing beams (parallel beams) arranged in parallel with each other is fixed to a case at a proximal end of each beam and external force is applied to a distal end of each beam in a downward direction thereof.
Fig. 9 is a diagram schematically illustrating stress (extension stress or contraction stress) caused in a pair of parallel beams in a state that external force is applied to a distal end of each beam in the downward direction thereof.
Fig. 10 is a graph illustrating a relationship between magnetic field (H) applied to the magnetostrictive rod and magnetic flux density (B) in the magnetostrictive rod in accordance with stress caused in the magnetostrictive rod formed of a magnetostrictive material containing the iron-gallium based alloy (having a Young's modulus of about 70 GPa) as the main component thereof.
Fig. 11 is a perspective view showing a power generator having a configuration in which a space between a magnetostrictive rod and a beam portion is equal from a proximal end thereof to a distal end thereof by modifying a part of the power generator shown in Fig. 1.
Fig. 12(a) is an analysis diagram illustrating an analysis result of stress caused in the magnetostrictive rod and the beam portion of the power generator shown in Fig. 11.
Fig. 12(b) is an analysis diagram illustrating an analysis result of stress caused in the magnetostrictive rod and the beam portion of the power generator shown in Fig. 1.
Fig. 13 is a planar view showing another configuration example of a power generator according to the first embodiment of the present invention.
Fig. 14 is a perspective view showing a power generator according to a second embodiment of the present invention.
Fig. 15 is a perspective view showing a power generator according to a third embodiment of the present invention.

Figs. 16(a) and 16(b) are perspective views showing the bobbin of the coil of the power generator shown in Fig. 15.

Figs. 17(a) and 17(b) are perspective views showing the magnetostrictive rod and the coil of the power generator shown in Fig. 15.

Fig. 17(c) is a cross-sectional perspective view of the magnetostrictive rod and the coil taken along a B-B line shown in Fig. 17(a).

Fig. 18(a) is a side view explaining a state in which the power generator shown in Fig. 15 is fixedly attached to a vibrating body.

Fig. 18(b) is a longitudinal cross-sectional view (taken along an A-A line shown in Fig. 15) showing the power generator shown in Fig. 15 fixedly attached to the vibrating body.

Fig. 19 is a side view showing another configuration example of a power generator according to the first embodiment of the present invention.

Fig. 20(a) is a graph illustrating stress distribution caused in the magnetostrictive rod along the longitudinal direction thereof at each region of the thickness direction thereof when external force is applied to the second block body 5 of the power generator according to Example 1 of the present invention in a downward direction thereof.

Fig. 20(b) is a graph illustrating a result obtained by conducting the same measurement as illustrated in Fig. 20(a) for the power generator according to Example 2 of the present invention.

Fig. 20(c) is a graph illustrating a result obtained by conducting the same measurement as illustrated in Fig. 20(a) for the power generator according to Example 3 of the present invention.

## DETAILED DESCRIPTION OF THE PREFERRED EMBODIMENTS

Hereinafter, a power generator of the present invention will be described in detail with reference to preferred embodiments shown in the accompanying drawings.

<First embodiment>

First, description will be given to a power generator according to a first embodiment of the present invention.

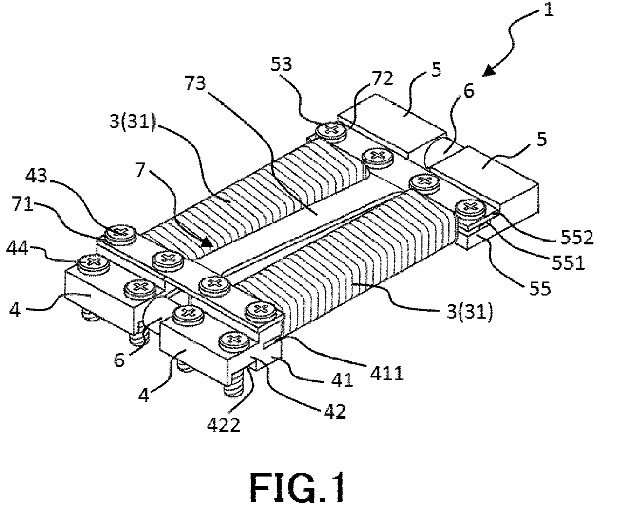

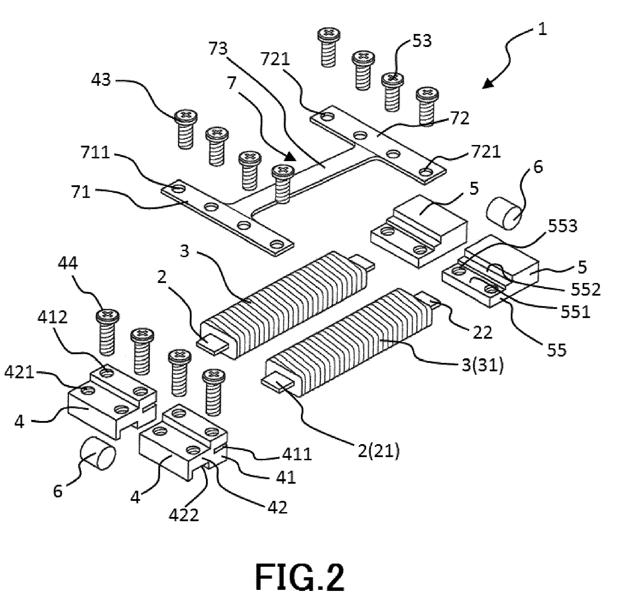

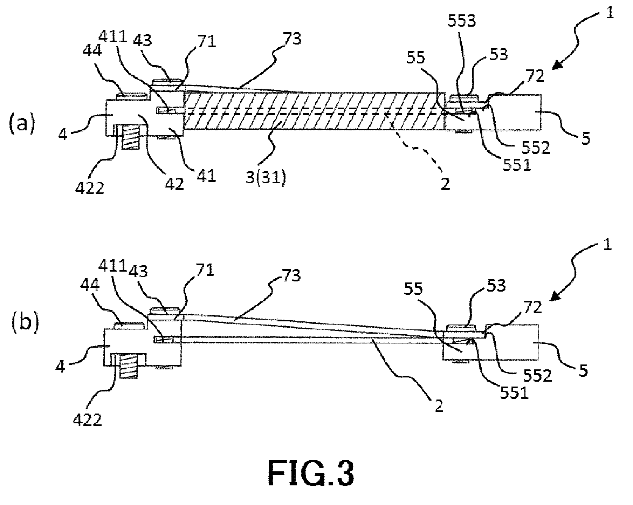

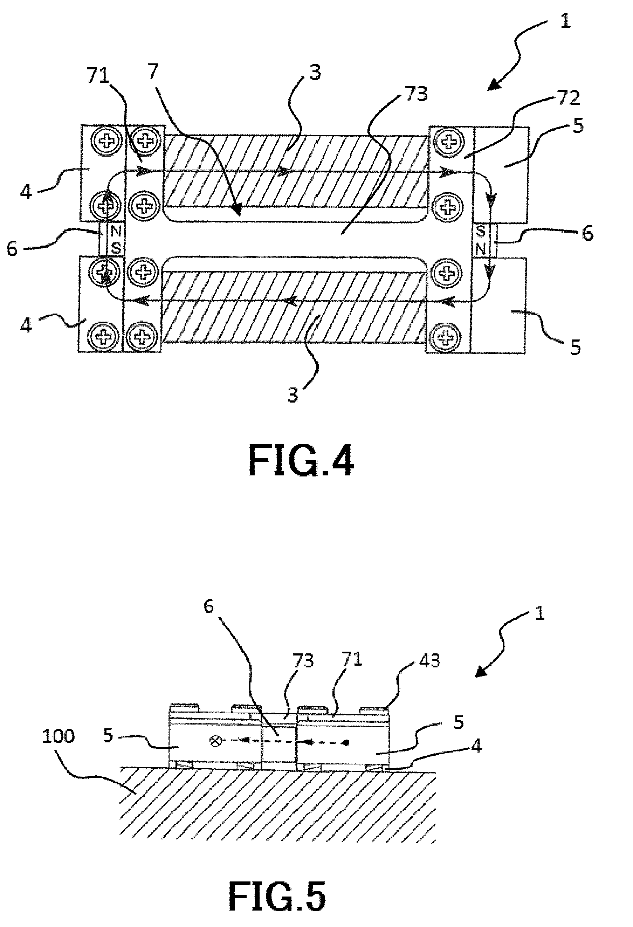

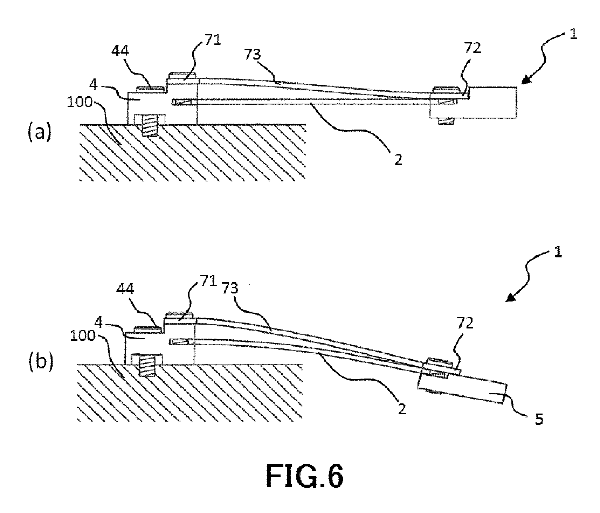

Fig. 1 is a perspective view showing a power generator according to a first embodiment of the present invention. Fig. 2 is an exploded perspective view showing the power generator shown in Fig. 1. Fig. 3(a) is a side view showing the power generator shown in Fig. 1. Fig. 3(b) is a side view showing the power generator shown in Fig. 3(a) from which a coil is removed from each magnetostrictive rod. Fig. 4 is a planar view showing the power generator shown in Fig. 1. Fig. 5 is a front view showing the power generator shown in Fig. 1. Fig. 6(a) is a right side view showing a state in which the power generator (the coil is omitted) shown in Fig. 1 is fixedly attached to a vibrating body. Fig. 6(b) is a right side view showing a state in which external force is applied to a distal end of the power generator shown in Fig. 6(a) in a downward direction thereof.

Hereinafter, an upper side in each of Figs. 1, 2, 3(a), (b), 5 and 6(a), (b) and a front side of the paper in Fig. 4 are referred to as "upper" or "upper side" and a lower side in each of Figs. 1, 2, 3(a), (b), 5 and 6(a), (b) and a rear side of the paper in Fig. 4 are referred to as "lower" or "lower side". Further, a right rear side of the paper in each of Figs. 1 and 2 and a right side in each of Figs. 3(a), 3(b), 4 and 6(a), (b) are referred to as "distal side" and a left front side of the paper in each of Figs. 1 and 2 and a left side in each of Figs. 3(a), 3(b), 4 and 6(a), (b) are referred to as "proximal side".

A power generator 1 shown in Figs. 1 and 2 has at least one magnetostrictive rod 2 (specifically, two magnetostrictive rods 2, 2 in this embodiment) through which lines of magnetic force pass in an axial direction thereof, a beam portion 73 having a function of causing stress in the magnetostrictive rod 2, and a coil 3 provided so that the lines of magnetic force pass inside the coil 3 in an axial direction of the coil 3. The power generator 1 is configured so that a distal end (the other end) of each magnetostrictive rod 2 can be relatively displaced toward a direction substantially perpendicular to an axial direction of each magnetostrictive rod 2 with respect to a proximal direction (one end) of the magnetostrictive rod 2. Namely, the power generator 1 is configured so that the other end of each magnetostrictive rod 2 can be displaced in a vertical direction in Fig. 1 with respect to the one end of each magnetostrictive rod 2. By this displacement of the other end of each magnetostrictive rod 2, the magnetostrictive rod 2 can be expanded and contracted. At this time, magnetic permeability of each magnetostrictive rod 2 varies due to an inverse magnetostrictive effect. This variation of the magnetic permeability of each magnetostrictive rod 2 leads to variation of density of the lines of magnetic force passing through each magnetostrictive rod 2 (density of lines of magnetic force passing through the coil 3), and thereby generating a voltage in the coil 3.

In the power generator 1, a space between the magnetostrictive rod 2 and the beam portion 73 at the other end of the magnetostrictive rod 2 is smaller than that at the one end of the magnetostrictive rod 2 in a side view of the power generator 1. In such a configuration, a stiffness in a displacement direction of a pair of opposed beams formed from the magnetostrictive rod 2 and the beam portion 73 becomes gradually lower from a proximal end thereof toward a distal end thereof. With such a configuration, when external force is applied to the distal end of the magnetostrictive rod 2, it is possible to smoothly displace the magnetostrictive rod 2 and the beam portion 73 in the displacement direction. Therefore, it is possible to make variability of stress caused in the thickness direction of the magnetostrictive rod 2 small. As a result, it is possible to cause uniform stress in the magnetostrictive rod 2 to thereby improve the power generating efficiency of the power generator 1.

Hereinafter, description will be given to a configuration of each component of the power generator 1 of the present invention.

(Magnetostrictive rod 2)

As shown in Figs. 1 and 2, the power generator 1 of this embodiment has two magnetostrictive rods 2, 2 arranged in parallel with each other. Each of the magnetostrictive rods 2, 2 is formed of the magnetostrictive material as previously described and arranged so that a direction in which magnetization is easily generated (an easy magnetization direction) becomes the axial direction thereof. In this embodiment, the magnetostrictive rod 2 has a plate-like shape so that the lines of magnetic force pass through the magnetostrictive rod 2 in the axial direction thereof.

The thickness (cross-sectional area) of the magnetostrictive rod 2 is substantially constant along the axial direction of the magnetostrictive rod 2. An average thickness of the magnetostrictive rod 2 is not particularly limited to a specific value, but is preferably in the range of about 0.3 to 10 mm, and more preferably in the range of about 0.5 to 5 mm. Further, an average value of the cross-sectional area of the magnetostrictive rod 2 is preferably in the range of about 0.2 to 200 mm$^2$, and more preferably in the range of about 0.5 to 50 mm$^2$. With such a configuration, it is possible to reliably pass the lines of magnetic force through the magnetostrictive rod 2 in the axial direction thereof.

A Young's modulus of the magnetostrictive material is preferably in the range of about 40 to 100 GPa, more preferably in the range of 50 to 90 GPa, and even more preferably in the range of about 60 to 80 GPa. By forming the magnetostrictive rod 2 with the magnetostrictive material having the above Young's modulus, it is possible to expand and contract the magnetostrictive rod 2 more drastically. Since this allows the magnetic permeability of the magnetostrictive rod 2 to vary more drastically, it is possible to more improve the power generating efficiency of the power generator 1 (the coil 3).

The magnetostrictive material having the above Young's modulus is not particularly limited to a specific kind. Examples of such a magnetostrictive material include an iron-gallium based alloy, an iron-cobalt based alloy, an iron-nickel based alloy and a combination of two or more of these materials. Among them, a magnetostrictive material containing an iron-gallium based alloy (having a Young's modulus of about 70 GPa) as a main component thereof is preferably used. A Young's modulus of the magnetostrictive material containing the iron-gallium based alloy as the main component thereof can be easily adjusted to fall within the above range.

Further, it is preferred that the magnetostrictive material described above contains at least one of rare-earth metal such as Y, Pr, Sm, Tb, Dy, Ho, Er and Tm. By using the magnetostrictive material containing at least one rare-earth metal mentioned above, it is possible to make the variation of the magnetic permeability of the magnetostrictive rod 2 larger.

The coil 3 is wound (arranged) around each magnetostrictive rod 2 so as to surround a part of the magnetostrictive rod 2 except for both end portions 21, 22.

(Coil 3)

The coil 3 is formed by winding a wire 31 around the magnetostrictive rod 2. With such a configuration, the coil 3 is provided so that the lines of magnetic force passing through the magnetostrictive rod 2 pass inside the coil 3 (an inner cavity of the coil 3) in an axial direction of the coil 3 (in this embodiment, the axial direction of the coil 3 is equivalent to the axial direction of the magnetostrictive rod 2). Due to the variation of the magnetic permeability of the magnetostrictive rod 2, that is, due to the variation of the density of the lines of magnetic force (magnetic flux density) passing through the magnetostrictive rod 2, the voltage is generated in the coil 3.

In the present invention, the magnetostrictive rods 2, 2 are arranged in parallel with each other with a predetermined space therebetween. Therefore, by adjusting the space adequately, it is possible to obtain a sufficient space for the coil 3 wound around each magnetostrictive rod 2. With such a configuration, in the case where a wire 31 having a relatively large cross-sectional area (a wire diameter) is used for the coil 3, a winding number of the wire 31 can be made large. Since such a wire with a large wire diameter has a small resistance value (load impedance) to thereby allow an electric current flow sufficiently therethrough, the voltage generated in the coil 3 can be efficiently utilized.

Here, the voltage "$\varepsilon$" generated in the coil 3 due to variation of magnetic flux density in the magnetostrictive rod 2 can be expressed by the following equation (1).

$$\varepsilon = N \times \Delta B / \Delta T \quad (1)$$

wherein in the above equation (1), "N" is a winding number of the wire 31, "ΔB" is an amount of variation of magnetic flux passing through the inner cavity of the coil 3, and "ΔT" is an amount of time variation.

In the above equation (1), the voltage ε generated in the coil 3 is proportional to the winding number of the wire 31 and the variation of magnetic flux density (ΔB/ΔT) in the magnetostrictive rod 2. Therefore, by making the winding number of the wire 31 large, it is possible to improve the power generating efficiency of the power generator 1.

A constituent material of the wire 31 is not particularly limited to a specific type. Examples of the constituent material of the wire 31 include a wire obtained by covering a copper base line with an insulating layer, a wire obtained by covering a copper base line with an insulating layer to which an adhesive (fusion) function is imparted and a combination of two or more of these wires.

The winding number of the wire 31 is not particularly limited to a specific value, but is preferably in the range of about 1000 to 10000, and more preferably in the range of about 2000 to 9000. With such a configuration, it is possible to more increase the voltage generated in the coil 3.

Further, the cross-sectional area of the wire 31 is not particularly limited to a specific value, but is preferably in the range of about $5 \times 10^{-4}$ to 0.15 mm$^2$, and more preferably in the range of about $2 \times 10^{-3}$ to 0.08 mm$^2$. Since the wire 31 with such wire diameter of the above range has a sufficiently small resistance value, it is possible to efficiently output the electric current flowing in the coil 3 to the outside. As a result, it is possible to improve the power generating efficiency of the power generator 1.

A cross-sectional shape of the wire 31 may be any shape. Examples of the cross-sectional shape of the wire 52 include a polygonal shape such as a triangular shape, a square shape, a rectangular shape and a hexagonal shape; a circular shape and an elliptical shape.

The first block body 4 is provided on the proximal end side of each magnetostrictive rod 2.

(First block body 4)

The first block body 4 serves as a fixation portion for fixing the power generator 1 to a vibrating body generating vibration. When the power generator 1 is fixed to the vibrating body through the first block body 4, the magnetostrictive rod 2 is supported in a cantilevered state in which the proximal end of the magnetostrictive rod 2 serves as a fixed end and the distal end of the magnetostrictive rod 2 serves as a movable end. In this regard, Examples of the vibrating body to which the first block body 4 is fixedly attached include various kinds of vibrating bodies such as an air-conditioning duct. Specific examples of the vibrating body are described later.

As shown in Figs. 1 and 2, the first block body 4 includes a tall block part 41 located at a distal end portion thereof and a short block part 42 located at a proximal end portion thereof. The short block part 42 has lower height than the tall block part 41. Namely, an outer shape of the first block body 4 is a stair-like shape (a step-like shape).

Almost in a center of a thickness direction of the tall block part 41, a slit 411 is formed so as to extend along a width direction of the tall block part 41, and the proximal end portion 21 of the magnetostrictive rod 2 is inserted in the slit 411. Further, in both end portions of the width direction of the tall block part 41, a pair of female thread portions 412 is formed so as to pass through the tall block part 41 in the thickness direction thereof, and male thread portions (male screws) 43 are screwed thereinto.

In both end portions of a width direction of the short block part 42, a pair of female thread portions 421 is formed so as to pass through the short block part 42 in the thickness direction thereof, and male thread portions (male screws) 44 are screwed thereinto. By screwing the male thread portions 44 into a casing or the like (the vibrating body) through the female thread portions 421, the first block body 4 can be fixed to the casing or the like.

Further, in a lower surface of the short block part 42, a groove 422 is formed so as to extend along a width direction of the short block part 42. With such a configuration, since the first block body 4 is fixed to the vibrating body through two parts formed of the distal end portion having the groove 422 (the short block part 42) and the proximal end portion (mainly, the tall block part 41), first block body 4 is configured so as to be easily deformed at a vicinity of the groove 422. This makes it possible to efficiently transmit the vibration of the vibrating body to the distal end portion of the magnetostrictive rod 2 (the second block body 5) through the first block body 4. As a result, extension stress or contraction stress can be efficiently caused in the magnetostrictive rod 2.

On the other hand, the second block body 5 is provided on the distal end side of each magnetostrictive rod 2.

(Second block body 5)

The second block body 5 serves as a weight for applying external force or vibration to the magnetostrictive rod 2. When the vibrating body vibrates, external force in the vertical direction or vibration in the vertical direction is applied to the second block body 5. By applying the external force or the vibration to the magnetostrictive rod 2, the magnetostrictive rod 2 begins reciprocating motion in the vertical direction under the cantilevered state, in which the proximal end portion of the magnetostrictive rod 2 serves as the fixed end portion and the distal end portion of the magnetostrictive rod 2 serves as the movable end portion.

As shown in Figs. 1 and 2, the second block body 5 has a substantially rectangular parallelepiped shape and includes a step portion 55 located at a proximal end portion thereof and formed into a stair-like shape (a step-like shape) so as to become lower by two-steps than a distal end of the second block body 5 in the same manner as the above first block body 4. The step portion 55 has a first step surface 551 located at a proximal end side thereof and a second step surface 552 located at a distal end side of a part of the step portion 55 forming the first step surface 551 and provided so as to become higher by one-step than the first step surface 551. The distal end 22 of the magnetostrictive rod 2 is placed on the first step surface 551, and a part of the first connecting portion 71 is placed on the second step surface 552. In this embodiment, the power generator 1 is configured so that a height (a length) from the second step surface 552 to the first step surface 551 in the second block body 5 is substantially equal to the thickness of the distal end 22 of the magnetostrictive rod 2.

Further, in both end portions of a width direction of the first step surface 551, a pair of female thread portions 553 is formed so as to pass through the step portion 55 in the thickness direction thereof, and two male thread portions (male screws) 53 are screwed thereinto.

A constituent material of each of the first block body 4 and the second block body 5 is not particularly limited to a specific kind as long as it has an enough stiffness for reliably fixing the end portions 21, 22 of the magnetostrictive rod 2 to each block body 4, 5 and applying uniform stress to the magnetostrictive rod 2 and enough ferromagnetism for applying a bias magnetic field of the permanent magnet 6 to the magnetostrictive rod 2. Examples of the constituent material having the above properties include a pure iron (e.g., "JIS SUY"), a soft iron, a carbon steel, a magnetic steel (silicon steel), a high-speed tool steel, a structural steel (e.g., "JIS SS400"), a stainless, a permalloy and a combination of two or more of these materials.

Further, a width of each of the first and second block bodies 4, 5 is adjusted so as to become larger than that of the magnetostrictive rod 2. Specifically, the first block body 4 has the width for enabling the magnetostrictive rod 2 to be arranged between the pair of female thread portions 412 when the proximal end portion 21 of the magnetostrictive rod 2 is inserted into the slit 411 of the first block body 4. Further, the second block body 5 has the width for enabling the magnetostrictive rod 2 to be arranged between the pair of female thread portions 553 when the distal end portion 22 of the magnetostrictive rod 2 is placed on the first step surface 551 of the second block body 5. The width of each of the first and second block bodies 4, 5 is preferably in the range of about 3 to 15 mm, and more preferably in the range of about 5 to 10 mm. With such a configuration, it is possible to obtain the sufficient space for the coil 3 wound around each magnetostrictive rod 2, while downsizing the power generator 1.

The two permanent magnets 6, 6 for applying the bias magnetic field to each magnetostrictive rod 2 are provided between the first block bodies 4 and between the second block bodies 5, respectively.

(Permanent magnet 6)

Each permanent magnet 6 has a cylindrical shape.

As shown in Fig. 4, the permanent magnet 6 provided between the first block bodies 4 is arranged so that its south pole faces to a lower side in Fig. 4 and its north pole faces to an upper side in Fig. 4. Further, the permanent magnet 6 provided between the second block bodies 5 is arranged so that its south pole faces to the upper side in Fig. 4 and its north pole faces to the lower side in Fig. 4. Namely, each permanent magnet 6 is arranged between the magnetostrictive rods 2, 2 so that a magnetization direction thereof is directed to an arrangement direction of the magnetostrictive rods 2, 2. In other words, each permanent magnet 6 is arranged between the magnetostrictive rods 2, 2 in a state that the magnetization direction thereof is directed along a line connecting the magnetostrictive rods 10, 10 (see Fig. 5 and the like). Due to this arrangement, it is possible to form a magnetic field loop circulating in a clockwise direction in the power generator 1.

As each permanent magnet 6, it is possible to use an alnico magnet, a ferrite magnet, a neodymium magnet, a samarium-cobalt magnet, a magnet (a bonded magnet) obtained by molding a composite material prepared by pulverizing and mixing at least one of these magnets with a resin material or a rubber material, or the like. The permanent magnets 6, 6 are preferably fixed to the first and second block bodies 4, 5 with, for example, a bonding method using an adhesive agent or the like.

In this regard, the power generator 1 is configured so that the permanent magnet 6 provided between the second block bodies 5 is displaced together with the second block bodies 5. Therefore, a friction is not generated between each second block body 5 and the permanent magnet 6 provided between the second block bodies 5. Therefore, since an energy for displacing the second block bodies 5 is not consumed due to the friction, the

power generator 1 can efficiently generate the electric power.

The magnetostrictive rods 2, 2 are connected with the connecting member 7 through the first block bodies 4 and the second block bodies 5.

(Connecting member 7)

The connecting member 7 includes a first connecting portion 71 connecting the first block bodies 4 together, a second connecting portion 72 connecting the second block bodies 5 together and one beam portion 73 connecting the first connecting portion 71 and the second connecting portion 72.

In this embodiment, each of the first connecting portion 71, the second connecting portion 72 and the beam portion 73 has a belt-like shape (a longitudinal plate-like shape), and an outer shape of the connecting member 7 is an H-shape in planar view thereof. The connecting member 7 may be formed of the first connecting portion 71, the second connecting portion 72 and the beam portion 73 connected to each other with a welding method and the like, but it is preferred that these portions 71, 72 and 73 are integrally formed.

In this embodiment, the power generator 1 is configured so that the first connecting portion 71 makes contact with the upper surface of the tall block part 41 and a part of the second connecting portion 72 makes contact with the second step surface 552 of the second block body 5.

As shown in Figs. 3(a) and (b), the power generator 1 is configured so that in the side view thereof, a height (a length) from the upper surface of the tall block body 41 to the lower surface of the tall block body 41 (a thickness of the tall block body 41) is larger than a height (a length) from the second step surface 552 to the lower surface of the second block body 5 (a thickness of the second block body 5 at the second step surface 552). Therefore, the power generator 1 is configured so that a distance between the magnetostrictive rod 2 and the first connecting portion 71 becomes larger than a distance between the magnetostrictive rod 2 and the second connecting portion 72. With such a configuration, the space between the magnetostrictive rod 2 and the beam portion 73 connecting the first connecting portion 71 and the second connecting portion 72 at the distal end of the magnetostrictive rod 2 is smaller than that at the proximal end of the magnetostrictive rod 2 in a side view of the power generator 1.

The connecting portion 7 may be formed by preparing the connecting portion 7 of the power generator 1 of the first embodiment, and then bending the first connecting portion 71 and the second connecting portion 72 in the opposite direction with respect to the beam portion 73 using a pressing work, a bending work or a forging work and the like. By using such methods, it is possible to easily adjust an angle between the first connecting portion 71 and the beam portion 73 and an angle between the second connecting portion 72 and the beam portion 73.

Four through-holes 711 are formed in the first connecting portion 71 so as to pass through the first connecting portion 71 in a thickness direction thereof. Further, the through-holes 711 are formed so that positions of the through-holes 711 correspond to the four female thread portions 412 of the two first block bodies 4, respectively. In this embodiment, the proximal end portion 21 of the magnetostrictive rod 2 is inserted in the slit 411, and then the male thread portions 43 are inserted into the through-holes 711 of the first connecting portion 71 and screwed into the female thread portions 412 of each first block body 4. This makes it possible to couple the first connecting portion 71 to the tall block body 41 (the first block body 4) with the male thread portions 43 and fix the proximal end portion 21 (the magnetostrictive rod 2) to the first block body 4 due to reduction of a gap of the slit 411 by screwing the male thread portions 43.

Four through-holes 721 are formed in the second connecting portion 72 so as to pass through the second connecting portion 72 in a thickness direction thereof. Further, the through-holes 721 are formed so that positions of the through-holes 721 correspond to the four female thread portions 553 of the two second block bodies 5, respectively. In this embodiment, the distal end portion 22 of the magnetostrictive rod 2 is placed on the first step surface 551 of the second block body 5, and the distal end portion of the second connecting portion 72 is made in contact with the second step surface 552 of the second block body 5. In this state, the male thread portions 53 are inserted into the through-holes 721 of the second connecting portion 72 and screwed into the female thread portions 553 of each second block body 5. With such a configuration, the second connecting portion 72 is coupled to the second block body 5 with the male thread portions 53 and the distal end portion 22 (the magnetostrictive rod 2) is held between a lower surface of the second connecting portion 72 and the first step surface 551 so as to be fixed to the second block body 5.

As described above, the magnetostrictive rod 2 and the first connecting portion 71 are fastened to the first block body 4 by the male thread portions 43, and the magnetostrictive rod 2 and the second connecting portion 72 are fastened to the second block body 5 by the male thread portions 53. With such a configuration, a number of parts for fixing and/or connecting the component members constituting the power generator 1 and a number of assembling step can be reduced. In this regard, the fixing method is not limited to the coupling method with screws, fixing methods such as a bonding method using an adhesive agent, a brazing method, a laser welding method and electric welding may be used.

Further, by adjusting lengths of the first connecting portion 71 and the second connecting portion 72, it is possible to adjust (design) the space between the magnetostrictive rods 2, 2. Therefore, by making the space between the magnetostrictive rods 2, 2 large, it is possible to obtain the sufficient space for the coil 3 wound around each magnetostrictive rod 2. This makes it possible to make a diametrical size of the coil 3 large. As a result, it is possible to improve the power generating efficiency of the power generator 1.

The beam portion 73 connects a central portion of the first connecting portion 71 and a central portion of the second connecting portion 72 together. Further, in a planar view of the power generator 1, the beam portion 73 and each magnetostrictive rod 2 are arranged so as not to be overlapped with each other (Fig. 1), and the space between the beam portion 73 and each magnetostrictive rod 2 at the distal end of the magnetostrictive rod 2 is smaller than that at the proximal end of the magnetostrictive rod 2 in the side view of the power generator 1 (Fig. 3). In this embodiment, a width of the beam portion 73 is adjusted so as to become smaller than the space between the coils 3 wound around the magnetostrictive rods 2, 2. Further, in the side view of the power generator 1, the beam portion 73 and each magnetostrictive rod 2 are arranged so as to be overlapped with each other at the distal end side thereof.

In the power generator 1, the magnetostrictive rods 2, 2 and the beam portion 73 serve as a pair of opposed beams. Each magnetostrictive rod 2 and the beam portion 73 are displaced toward the same direction (an upward direction or a downward direction in Fig. 1) by a displacement of the second block body 5. At this time, external force is applied to each magnetostrictive rod 2 by the beam portion 73. Since the beam portion 73 is arranged between the magnetostrictive rods 2, 2, there is no possibility that each magnetostrictive rod 2 and the beam portion 73 make contact with each other by a displacement of the magnetostrictive rod 2.

In the power generator 1, the first block body 4 is fixed to the casing 100 as a vibrating body by screwing the male thread portions 44 (see Fig. 6(a)). In this state, when the second block body 5 is displaced (rotated) toward the lower side with respect to the first block body 4 due to the vibration of the vibrating body, that is, when the distal end of the magnetostrictive rod 2 is displaced toward the lower side with respect to the proximal end of the magnetostrictive rod 2, the beam portion 73 is deformed so as to be expanded in the axial direction thereof and the beam portion 73 is deformed so as to be contracted in the axial direction thereof (see Fig. 6(b)). On the other hand, when the second block body 5 is displaced (rotated) toward the upper side with respect to the first block body 4, that is, when the distal end of the magnetostrictive rod 2 is displaced toward the upper side with respect to the proximal end of the magnetostrictive rod 2, the beam portion 73 is deformed so as to be contracted in the axial direction thereof and the beam portion 73 is deformed so as to be expanded in the axial direction thereof. As a result, the magnetic permeability of the magnetostrictive rod 2 varies due to the inverse magnetostrictive effect. This variation of the magnetic permeability of the magnetostrictive rod 2 leads to the variation of the density of the lines of magnetic force passing through the magnetostrictive rod 2 (density of the lines of magnetic force passing through the inner cavity of the coil 3 along the axial direction of the magnetostrictive rod 2), and thereby generating the voltage in the coil 3.

As described above, in the power generator 1, the space between each of the magnetostrictive rods 2, 2 and the beam portion 73 (hereinafter, referred to as "space between beams") at the distal end of the magnetostrictive rod 2 is smaller than that at the proximal end of the magnetostrictive rod 2 in the side view of the power generator 1. In other words, the magnetostrictive rod 2 (the magnetostrictive rods 2, 2) and the beam portion 73 form a beam structure (a tapered beams configuration) which is tapered from the proximal end thereof toward the distal end thereof (see Fig. 3(b)). In such a configuration, a stiffness in the displacement direction (the vertical direction) of a pair of opposed beams formed from the magnetostrictive rod 2 and the beam portion 73 becomes gradually lower from a proximal end thereof toward a distal end thereof. With such a configuration, when the external force is applied to the distal end (the second block body 5) of the power generator 1, it is possible to smoothly displace the magnetostrictive rod 2 and the beam portion 73 in the vertical direction. As a result, it is possible to make variability of stress caused in the thickness direction of the magnetostrictive rod 2 small. As a result, it is possible to cause uniform stress in the magnetostrictive rod 2 to thereby improve the power generating efficiency of the power generator 1.

Further, in the power generator 1, it is possible to freely adjust a space between the magnetostrictive rods 2, 2 and the beam portion 73 in the side view of the power generator 1. Specifically, by adjusting the length (height) from the upper surface of the tall block part 41 to the slit 411 in the first block body 4, it is possible to freely adjust the space between beams.

In this regard, a relationship between the space between the pair of opposed beams and the stress caused in the beams when external force is applied to a distal end thereof has been found by the present inventors, and from an analyzing results below, it has been found that by making the space between beams small, it is possible to cause uniform stress in each beam.

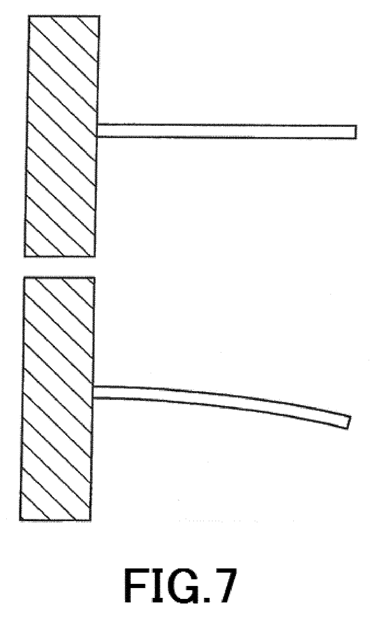

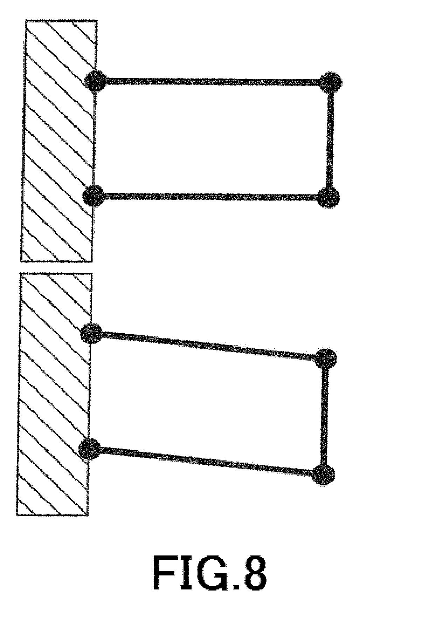

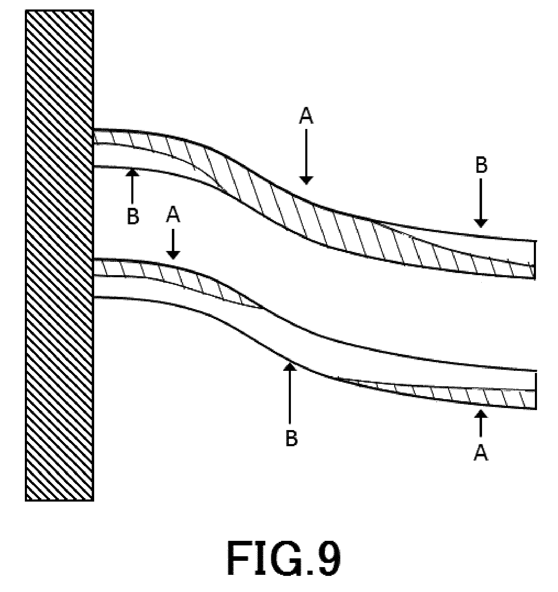

Fig. 7 is a side view schematically showing a state in which a rod (a beam) is fixed to a case at a proximal end thereof and external force is applied to a distal end of the rod in a downward direction thereof. Fig. 8 is a side view schematically showing a state in which a pair of opposing beams (parallel beams) arranged in parallel with each other is fixed to a case at a proximal end of each beam and external force is applied to a distal end of each beam in a downward direction thereof. Fig. 9 is a diagram schematically illustrating stress (extension stress or contraction stress / stress distribution) caused in a pair of parallel beams in a state that external force is applied to a distal end of each beam in the downward direction thereof.

Hereinafter, an upper side in Figs. 7 to 9 is referred to as "upper" or "upper side" and a lower side in Figs. 7 to 9 is referred to as "lower" or "lower side". Further, a right side in Figs. 7 to 9 is referred to as "distal side" and a left side in Figs. 7 to 9 is referred to as "proximal side".

As shown in Fig. 7, in the case where external force is applied to a distal end of a single beam toward the lower side with respect to a proximal end of the beam, stress is caused in the beam due to bending deformation of the beam (see the lower figure of Fig. 7). As a result, uniform tensile (extension) stress is caused at the upper side of the beam and uniform compressive (contraction) stress is caused at the lower side of the beam. On the other hand, as shown in Fig. 8, in the case where external force is applied to distal ends of parallel beams of which distal ends are coupled with each other through a coupling member to create a constant space between the parallel beams (hereinafter, simply referred to as "parallel beams"), each beam is not only bent as shown in Fig. 7 but also deformed so that the parallel beams are performed to provide a parallel link operation to maintain the space between the parallel beams at the distal ends thereof before and after applying the external force thereto as shown in Fig. 8 (see the lower figure of Fig. 8). In the parallel beams, the parallel link operation significantly appears as the space between the parallel beams is larger, and the parallel link operation, on the contrary, is suppressed as the space between the parallel beams is smaller so that each beam is deformed similar to the bending deformation of the single beam as shown in Fig. 7.

Therefore, in the parallel beams having a relatively large space between the parallel beams, each beam is deformed so as to form substantially S-shape as shown in Fig. 9 due to coexistence of the bending deformation and the deformation due to the parallel link operation. In more details, when the parallel beams are deformed toward the lower side, it is preferred that uniform extension stress is caused in the upper beam of the parallel beams. However, as shown in Fig. 9, large contraction stress B is caused at the lower side of a proximal end portion and the upper side of a distal end portion of the upper beam whereas large extension stress A is caused at a central portion of the upper beam. Further, when the parallel beams are deformed toward the lower side, it is preferred that uniform contraction stress is caused in the lower beam of the parallel beams. However, as shown in Fig. 9, large extension stress A is caused at the upper side of a proximal end portion and the lower side of a distal end portion of the lower beam whereas large contraction stress B is caused at a central portion of the lower beam. Namely, since both extension stress and contraction stress caused in each beam are large, it is impossible to make an absolute value of either the extension stress or the contraction stress caused in the whole of each beam large. Therefore, in the case where such a parallel beams configuration is used for magnetostrictive rods 2, 2, it is impossible to increase an amount of variation of the magnetic flux density in each magnetostrictive rod.

In this regard, in a magnetostrictive rod having one end and the other end, to which a bias magnetic field is applied, a value of stress (extension stress or contraction stress) caused therein and an amount of variation of magnetic flux density therein have a relationship as described below.

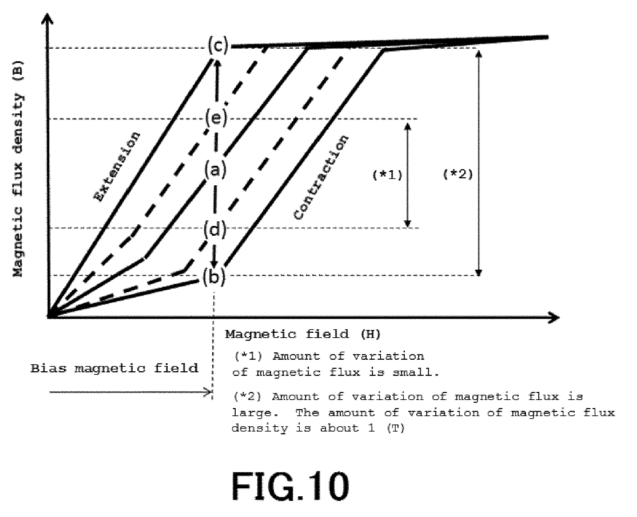

Fig. 10 is a graph illustrating a relationship between magnetic field (H) applied to the magnetostrictive rod and magnetic flux density (B) in the magnetostrictive rod in accordance with stress caused in the magnetostrictive rod formed of a magnetostrictive material containing the iron-gallium based alloy (having a Young's modulus of about 70 GPa) as the main component thereof.

In Fig. 10, a line (a) illustrates the relationship in a state that no stress is caused in the magnetostrictive rod. Further, a line (b) illustrates the relationship in a state that contraction stress of 90 MPa is caused in the magnetostrictive rod. Further, a line (c) illustrates the relationship in a state that extension stress of 90 MPa is caused in the magnetostrictive rod. Further, a line (d) illustrates the relationship in a state that contraction stress of 50 MPa is caused in the magnetostrictive rod. Further, a line (e) illustrates the relationship in a state that contraction stress of 50 MPa is caused in the magnetostrictive rod.

As shown in Fig. 10, in the magnetostrictive rod in which the extension stress is caused, the magnetic permeability of the magnetostrictive rod is high in comparison with the magnetostrictive rod in the state that no stress is caused therein so that the density of lines of magnetic force passing through the magnetostrictive rod is large (lines (c) and (e)). On the other hand, in the magnetostrictive rod in which the contraction stress is caused, the magnetic permeability of the magnetostrictive rod is low in comparison with the magnetostrictive rod in the state that no stress is caused therein so that the density of lines of magnetic force passing through the magnetostrictive rod is small (lines (b) and (d)).

Thus, in a state that a constant bias magnetic field is applied to the magnetostrictive rod as shown in Fig. 10, when the extension stress of 90 MPa and the contraction stress of 90 MPa are alternately caused in the magnetostrictive rod by vibrating (displacing) the other end of the magnetostrictive rod with respect to the one end the magnetostrictive rod, the amount of variation of the magnetic flux density in the magnetostrictive rod is about 1 T and becomes a maximum (see lines (b) and (c)). On the other hand, in the case of lowering the extension stress and the contraction stress alternately caused in the magnetostrictive rod to the extension stress of 50 MPa and the contraction stress of 50 MPa, respectively, the amount of variation of the magnetic flux density in the magnetostrictive rod is reduced (see lines (d) and (e)).

Therefore, it is necessary to make either the extension stress or the contraction stress caused in the magnetostrictive rod sufficiently large in order to make the amount of variation of the magnetic flux density in the magnetostrictive rod large. In this regard, in the magnetostrictive rod formed of the magnetostrictive material mentioned above, by alternately causing the extension stress of 70 MPa and the contraction stress of 70 MPa in the magnetostrictive rod, it is possible to make the amount of variation of the magnetic flux density in the magnetostrictive rod sufficiently large.

According to the above analyzing results, from a point of view of improving power generating efficiency in the power generator 1, it is preferred that by making the space between each magnetostrictive rod 2 and the beam portion 73 small, the parallel link operation of the beams (each magnetostrictive rod 2 and the beam portion 73) is suppressed so that each of the magnetostrictive rods 2, 2 and the beam portion 73 is deformed similar to the bending deformation of the single beam as shown in Fig. 7.

However, the present inventors has found that variability of stress caused in the thickness direction of the magnetostrictive rod 2 remains in the both ends of the magnetostrictive rod 2 whereas uniformity of stress caused in the magnetostrictive rod 2 is improved by making the space between each magnetostrictive rod 2 and the beam portion 73 small.

As a result of further examination conducted by the present inventors, it has also been found that by making the space between the magnetostrictive rod 2 and the beam portion 73 at the distal end of the magnetostrictive rod 2 smaller than that at the proximal end of the magnetostrictive rod 2 in a side view of the power generator 1, it is possible to reduce the variability of stress caused in the thickness direction of the magnetostrictive rod 2 remaining in the both ends of the magnetostrictive rod 2.

For the reasons described above, from a point of view of improving power generating efficiency in the power generator 1, it is preferred that by making the space between each magnetostrictive rod 2 and the beam portion 73 small while forming the tapered beams configuration with the magnetostrictive rod 2 and the beam portion 73, each of the magnetostrictive rods 2, 2 and the beam portion 73 is deformed similar to the bending deformation of the single beam as shown in Fig. 7. In the power generator 1, since the space for the coil 3 wound around each magnetostrictive rod 2 is not restricted due to the space between each magnetostrictive rod 2 and the beam portion 73, it is possible to adjust the space between each magnetostrictive rod 2 and the beam portion 73 to be sufficiently small, while maintaining the space for the coil 3 wound around each magnetostrictive rod 2. This makes it possible to cause uniform stress in the magnetostrictive rod 2 while maintaining the space for the coil 3 wound around each magnetostrictive rod 2. As a result, it is possible to improve the power generating efficiency of the power generator 1.

Further, in such a configuration, since the stiffness in the displacement direction of the pair of opposed beams formed of the magnetostrictive rod 2 and the beam portion 73 becomes low from a proximal end thereof to a distal end thereof, it is possible to largely deform the magnetostrictive rod 2 in the vertical direction by only applying a relatively small external force thereto in the same manner as the power generator 1 of the second embodiment.

In this regard, an angle between the magnetostrictive rod 2 and the beam portion 73 in the side view of the power generator 1 (a taper angle) is not particularly limited to a specific value, but is preferably in the range of about 0.5 to 10°, and more preferably in the range of about 1 to 7°. By adjusting the angle between the magnetostrictive rod 2 and the beam portion 73 in the side view in the above range, it is possible to make the space between the magnetostrictive rods 2, 2 and the beam portion 73 at the proximal end thereof sufficiently small, while forming the tapered beams configuration with the magnetostrictive rod 2 and the beam portion 73. This makes it possible to cause more uniform stress in the magnetostrictive rod 2.

It is preferred that a constituent material of the connecting member 7 is a material preventing the magnetic field loop formed between the magnetostrictive rods 2, 2 and the permanent magnets 6, 6 from being short-circuited via the connecting member 7 (the beam portion 73). Thus, it is preferred that the constituent material of the connecting member 7 is formed of either a feeble magnetic material or a non-magnetic material. However, from a point of view of more reliably preventing the magnetic field loop from being short-circuited, it is preferred that the constituent material of the connecting member 7 is formed of the non-magnetic material.

Further, a spring constant of the beam portion 73 may be different from that of each magnetostrictive rod 2, but it is preferred that the beam portion 73 has the spring constant of a sum of the spring constants of all the magnetostrictive rods 2, that is, a sum of the spring constants of the two magnetostrictive rods 2, 2. As described above, in the power generator 1 of this embodiment, the two magnetostrictive rods 2, 2 and the one beam portion 73 serve as the pair of opposed beams. Thus, by using the beam portion 73 (the connecting member 7) satisfying the above condition, it is possible to make a stiffness of the pair of opposed beams (the two magnetostrictive rods 2, 2 and the beam portion 73) in the vertical direction uniform. This makes it possible to smoothly and reliably displace the second block body 5 in the vertical direction with respect to the first block body 4.

Further, when in a beam supported in a cantilevered state in which one end thereof is fixed, external force "F" is applied to the other end of the beam, deflection "d" caused in the beam can be generally expressed by the following equation (2).

$$d = FL^3/3EI \quad (2)$$

wherein in the above equation (2), "L" is a length of the beam, "E" is a Young's modulus of a constituent material of the beam, and "I" is a cross-sectional secondary moment of the beam.

In the power generator 1, a cross-sectional area and a cross-sectional shape of each magnetostrictive rod 2 are substantially equal to a cross-sectional area and a cross-sectional shape of the beam portion 73, respectively. Thus, cross-sectional secondary moments of each magnetostrictive rod 2 and the beam portion 73 are substantially equal to each other. Further, a length of each magnetostrictive rod 2 is also substantially equal to a length of the beam portion 73. Therefore, according to the above equation (2), in the power generator 1 having the two magnetostrictive rods 2 and the one beam portion 73, it is preferred that a Young's modulus of the beam portion 73 is about twice as large as the Young's modulus of the beam portion 73. With such a configuration, the beams (the beam portion 73 and the two magnetostrictive rods 2) are similarly deformed (deflected) with each other. In other words, this makes it possible to balance the stiffness of the two magnetostrictive rods 2, 2 in the vertical direction and the stiffness of the beam portion 73 in the vertical direction.

The Young's modulus of the beam portion 73 (the constituent material of the beam portion 73) is preferably in the range of about 80 to 200 GPa, more preferably in the range of 100 to 190 GPa, and even more preferably in the range of about 120 to 180 GPa.

The non-magnetic material having the above Young's modulus is not particularly limited to a specific kind. Examples of such a non-magnetic material include a metallic material, a semiconductor material, a ceramic material, a resin material and a combination of two or more of these materials. In the case of using the resin material as the non-magnetic material for the connecting member 7, it is preferred that filler is added into the resin material. Among them, a non-magnetic material containing a metallic material as a main component thereof is preferably used. Further, a non-magnetic material containing at least one selected from the group consisting of stainless steel, beryllium copper, aluminum, magnesium, zinc, copper and an alloy containing at least one of these materials as a main component thereof is more preferably used.

In this regard, in the case where the magnetostrictive material containing the iron-gallium based alloy (having the Young's modulus of about 70 GPa) as the main component thereof is used as the constituent material of the magnetostrictive rod 2, it is preferred that the stainless steel (having a Young's modulus of about 170 GPa) is used as the constituent material of the connecting member 7. By forming each magnetostrictive rod 2 with the magnetostrictive material having the above Young's modulus and forming the connecting member 7 with the material having the above Young's modulus, it is possible to balance the stiffness of the two magnetostrictive rods 2, 2 in the vertical direction and the stiffness of the beam portion 73 in the vertical direction. This makes it possible smoothly and reliably displacing the second block body 5 in the vertical direction with respect to the first block body 4.

The thickness (cross-sectional area) of the beam portion 73 is substantially constant. An average thickness of the beam portion 73 is not particularly limited to a specific value, but is preferably in the range of about 0.3 to 10 mm, and more preferably in the range of about 0.5 to 5 mm. Further, an average value of the cross-sectional area of the beam portion 73 is preferably in the range of about 0.2 to 200 mm$^2$, and more preferably in the range of about 0.5 to 50 mm$^2$.

The air-conditioning duct to which the power generator 1 (the first block body 4) is fixedly attached is, for example, a duct or a pipe used for forming a flow channel in a device for delivering (emitting, ventilating, inspiring, wasting or circulating) gas such as steam, air and fuel gas and liquid such as water and fuel oil. Examples of the duct include an air-conditioning duct installed in a big center, building, station and the like. Further, the vibrating body is not limited to the air-conditioning duct. Examples of the vibrating body include a transportation (such as a freight train, an automobile and a back of truck), a crosstie for railroad, a wall panel of an express highway or a tunnel, a bridge, a vibrating device such as a pump and a turbine.

Here, the vibration of the vibrating body is unwanted vibration for delivering an objective medium (in the case of the air-conditioning duct, gas and the like passing through the duct). The vibration of the vibrating body normally results in noise and uncomfortable vibration. In the present invention, by fixedly attaching the power generator 1 to such a vibrating body, it is possible to generate electric energy in the power generator 1 converted from such unwanted vibration (kinetic energy).

The electric energy generated in the power generator 1 is utilized as a power supply of a sensor, a wireless device and the like. In a power generating system having the power generator 1, the sensor and the wireless device, the sensor can get measured data such as illumination intensity, temperature, pressure, noise and the like and then transmit the measured data to an external device through the wireless device. The external device can use the measured data as various control signals or a monitoring signal. Such a power generating system can be also used as a system for monitoring status of each component of vehicle (for example, a tire pressure sensor and a sensor for seat belt wearing detection). Further, by converting such unwanted vibration of the vibrating body to the electric energy in the power generator 1, it is possible to reduce the noise and the uncomfortable vibration generated from the vibrating body.

Further, by providing the power generator 1 with a mechanism for directly applying the external force to a distal end of the power generator 1 (the second block body 5) and combining the power generator 1 with a wireless device, it is possible to obtain a switch operated by a hand. Such a switch functions without being wired for a power supply and a signal line. Examples of the switch include a wireless switch for house lighting, a home security system (in particular, a system for wirelessly informing detection of operation to a window or a door) or the like.

Further, by applying the power generator 1 to each switch of a vehicle, it is not necessary to be wired for the power supply and the signal line. With such a configuration, it is possible to reduce a number of assembling step and a weight of a wire provided in the vehicle, and thereby achieving weight saving. This makes it possible to suppress a load on a tire, a vehicle body, an engine and to contribute to safety of the vehicle.

An amount of the electric power generated by the power generator 1 is not particularly limited to a specific value, but is preferably in the range of about 20 to 2000 μJ. If the amount of the electric power generated by the power generator 1 (power generating capability of the power generator 1) is in the above range, it is possible to efficiently use the power generator 1 for the wireless switch for house lighting, the home security system or the like described above in combination with a wireless communication device.

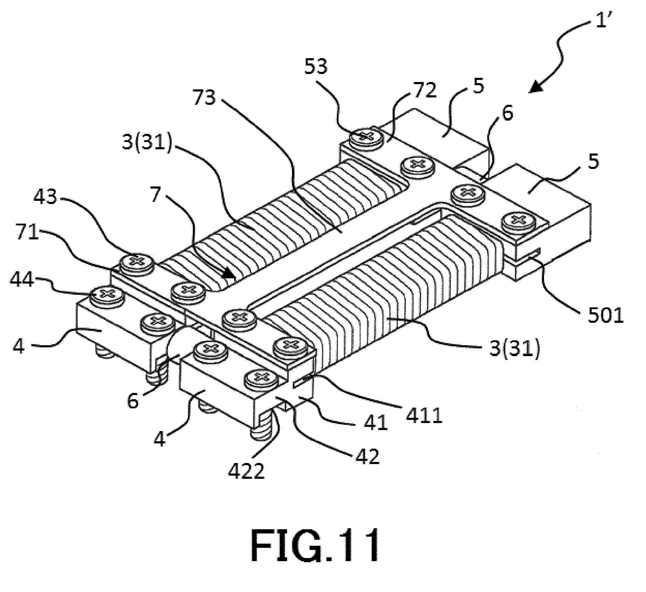

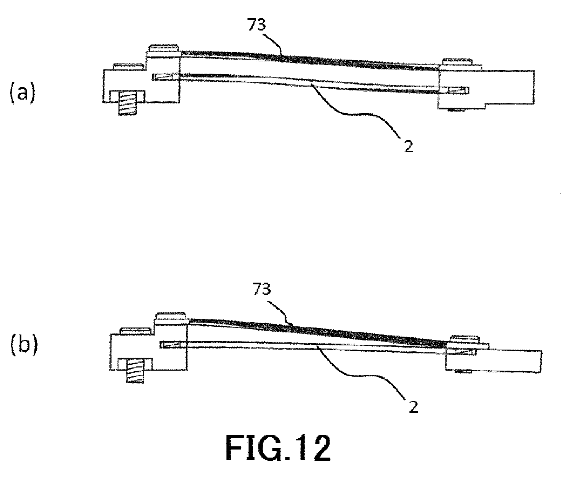

Hereinafter, when external force is applied to each distal end of the power generator 1 of this embodiment and the power generator 1' having a configuration in which a space between a magnetostrictive rod 2 and a beam portion 73 is equal from a proximal end thereof to a distal end thereof shown in Fig. 11, stress caused in each magnetostrictive rod 2 of the power generator 1 of this embodiment and the power generator 1'will be described in detail with reference to Figs. 11 and 12(a), (b).

Fig. 11 is a perspective view showing a power generator having a configuration in which a space between a magnetostrictive rod and a beam portion is equal from a proximal end thereof to a distal end thereof by modifying a part of the power generator shown in Fig. 1.

A power generator 1' has the same configuration as the power generator 1 according to the first embodiment except that the configuration of the second block body 5 is modified.

As shown in Fig. 11, the second block body 5, in the same manner as the first block body 4, has a substantially rectangular parallelepiped shape. Further, a slit 501 is formed at the proximal end side of the second block body 5. The slit 501 is formed almost in a center of a thickness direction of the second block body 5 so as to extend along a width direction of the second block body 5, and the distal end portion 22 of the magnetostrictive rod 2 is inserted in the slit 501. In this regard, the power generator 1' is configured so that a length from the upper surface to the slit 501 in the second block body 5 is substantially equal to a length from the upper surface of the tall block part 41 to the slit 411 in the first block body 4. With such a configuration, the second connecting portion 72 is coupled to the second block body 5 (the upper surface of the second block body 5) with the male thread portions 53 at the substantially same height as the first block body 4.

Fig. 12(a) is an analysis diagram illustrating an analysis result of stress caused in the magnetostrictive rod and the beam portion of the power generator shown in Fig. 11. Fig. 12(b) is an analysis diagram illustrating an analysis result of stress caused in the magnetostrictive rod and the beam portion of the power generator shown in Fig. 1. In this regard, in Figs. 12(a) and (b), a black marked portion shows a portion in which the extension stress is caused, and a white marked portion shows a portion in which the contraction stress is caused.

As shown in Fig. 12(a), in the power generator 1' shown in Fig. 11, when the external force is applied to the distal end of the power generator 1' toward the lower side, substantially uniform contraction stress is caused in the whole of the magnetostrictive rod 2 whereas extension stress is slightly caused at the upper side of the proximal end portion and the lower side of the distal end portion of the magnetostrictive rod 2. On the other hand, as shown in Fig. 12(b), in the power generator 1 of this embodiment, when the external force is applied to the distal end of the power generator 1 toward the lower side, uniform contraction stress is caused in the whole of the magnetostrictive rod 2.

In this regard, the power generator 1 may be configured so that the beam portion 73 applies an initial load to the magnetostrictive rod 2, that is, the beam portion 73 causes bias stress in the magnetostrictive rod 2.

For example, by making the length of the beam portion 73 shorter (smaller), the contraction stress is caused in the magnetostrictive rod 2 in a natural state thereof. In this case, when the external force is applied to the second block body 5 toward the upper side, the magnetostrictive rod 2 is largely deformed toward the upper side in comparison with a case that the bias stress is not caused in the magnetostrictive rod 2. With such a configuration, it is possible to cause larger contraction stress in the magnetostrictive rod 2 to thereby further improve the power generating efficiency of the power generator 1.

Further, by making the length of the beam portion 73 longer (larger), the extension stress is caused in the magnetostrictive rod 2 in a natural state thereof. In this case, when the external force is applied to the second block body 5 toward the lower side, the magnetostrictive rod 2 is largely deformed toward the lower side in comparison with a case that the bias stress is not caused in the magnetostrictive rod 2. With such a configuration, it is possible to cause larger extension stress in the magnetostrictive rod 2 to thereby further improve the power generating efficiency of the power generator 1.

Further, in the power generator 1 of this embodiment, although in the planar view of the power generator 1, the coil 3 and the beam portion 73 are arranged so as not to be overlapped with each other, the present invention is not limited thereto. For example, the power generator may be configured so that a part of the coil 3 and a pair of the beam portion 73 are arranged so as to be overlapped with each other. Specifically, the power generator may be configured so that in the planar view of the power generator, the magnetostrictive rod 2 and the beam portion 73 are arranged so as not to be overlapped with each other, but an outer peripheral end of each coil 3 and an outer peripheral end of the beam portion 73 are arranged so as not to be overlapped with each other. Even if the power generator has the above configuration, it is possible to obtain the sufficient space for the coil 3 wound around each magnetostrictive rod 2 and sufficiently make the space between the magnetostrictive rods 2, 2 and the beam portion 73 small to the extent that the coil 3 and the beam portion 73 do not make contact with each other. The power generator having the above configuration can also provide the same effects as the power generator 1 of this embodiment.

Further, although the power generator 1 of this embodiment has the two magnetostrictive rods 2, 2 and the one beam portion 73 serving as the pair of opposed beams, the power generator 1 of this embodiment is not limited thereto. The power generator 1 of this embodiment may have a configuration described below.

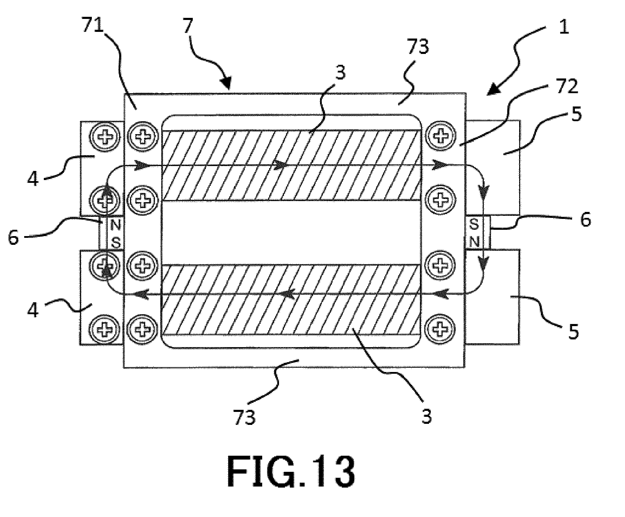

Fig. 13 is a planar view showing another configuration example of a power generator according to a first embodiment of the present invention.

In the power generator 1 shown in Fig. 13, the connecting member 7 includes two beam portions 73 connecting both end portions of a longitudinal direction of the first and second connecting portions 71, 72 together. With such a configuration, since each beam portion 73 is arranged outside the magnetostrictive rod 2, it is possible to make the space between magnetostrictive rods 2, 2 small, while making the diametrical size of the coil 3 large. This makes it possible to make a size in the width direction (the vertical direction in Fig. 13) of the power generator 1 small. In this regard, the power generator 1 having the above configuration can also provide the same effects as the power generator 1 of this embodiment.

Further, the power generator 1 of this embodiment may have two or more magnetostrictive rods 2 and one or more beam portion(s) 73. In the case where a total number of the magnetostrictive rods 2 and the beam portion 73 varies, it is preferred that the total number of the magnetostrictive rods 2 and the beam portion 73 is an odd number. Specifically, the power operator 1 may be configured so that a ratio of a number of the magnetostrictive rods 2 : a number of the beam portions 73 is 2:3, 3:2, 3:4, 4:3, 4:5 or the like. With such a configuration, since the magnetostrictive rods 2 and the beam portions 73 each serving as the beam are formed symmetrically in the width direction of the power generator 1, stresses caused in the magnetostrictive rods 2, each of the first and second block bodies 4, 5 and the connecting portion 7 are well-balanced.

In this regard, in such a configuration, when the spring constant of the beam portion 73 is defined as "A" [N/m], a number of the beam portion 73 is defined as "X" [pieces], a spring constant of the magnetostrictive rod 2 is defined as "B" [N/m], and a number of the magnetostrictive rod 2 is defined as "Y" [pieces], it is preferred that a value of "A $\times$ X" and a value of "B $\times$ Y" are substantially equal to each other. This makes it possible to smoothly and reliably displacing the second block body 5 in the vertical direction with respect to the first block body 4.

Further, in this embodiment, by screwing the male thread portions 43, 53 into the female thread portions 412, 502, the end portions 21, 22 of each magnetostrictive rod 2 and the first and second block bodies 4, 5 are fixed together and the connecting member 7 and the first and second block bodies 4, 5 are connected together, but a fixing method or a connecting method of these component members are not limited thereto. For example, these component members may be fixed or connected together by the fixing method or the connecting method such as press-fitting method using a pin, a welding method and a bonding method using an adhesive agent.

<Second embodiment>

Next, description will be given to a power generator according to a second embodiment of the present invention.

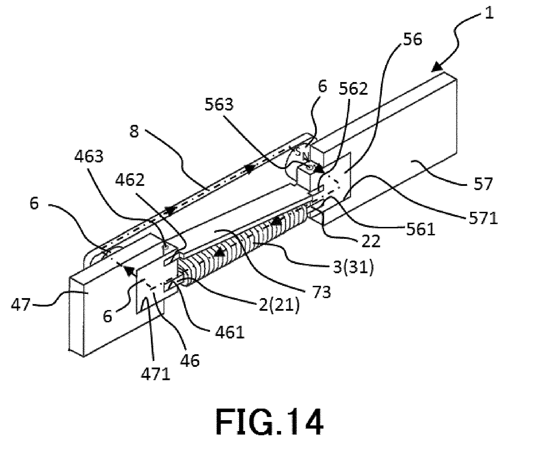

Fig. 14 is the perspective view showing a power generator according to a second embodiment of the present invention.

Hereinafter, an upper side in Fig. 14 is referred to as "upper" or "upper side" and a lower side in Fig. 14 is referred to as "lower" or "lower side". Further, a right rear side of the paper in Fig. 14 is referred to as "distal side" and a left front side of the paper in Fig. 14 is referred to as "proximal side".

Hereinafter, the power generator according to the second embodiment will be described by placing emphasis on the points differing from the power generator according to the first embodiment, with the same matters being omitted from description.

A power generator 1 shown in Fig. 14 has a magnetostrictive rod 2 around which a coil 3 is wound, a beam portion 73, a connecting yoke 46 connecting both proximal end portions of the magnetostrictive rod 2 and the beam portion 73 together, a connecting yoke 56 connecting both distal end portions of the magnetostrictive rod 2 and the beam portion 73 together, a yoke 8 arranged in parallel with the magnetostrictive rod 2 and the beam portion 73 and two permanent magnets 6, 6 provided between the connecting yoke 46 and the yoke 8 and between the connecting yoke 56 and the yoke 8, respectively. Further, the connecting yoke 46 is provided at a proximal end of the power generator 1 and is fixed to a support portion 47. Furthermore, the connecting yoke 56 is provided at a distal end of the power generator 1 and is fixed to a weight portion (mass portion) 57.

In the power generator 1 of this embodiment, the magnetostrictive rod 2 and the beam portion 73 are arranged in roughly parallel with each other with a predetermined space therebetween. In more details, in the same manner as the power generator 1 of the first embodiment, the power generator 1 of this embodiment is configured so that the space between the magnetostrictive rod 2 and the beam portion 73 at the distal end of the magnetostrictive rod 2 becomes gradually smaller than that at the proximal end of the magnetostrictive rod 2 in the side view of the power generator 1.

In this regard, the magnetostrictive rod 2, the coil 3 and the beam portion 73 of this embodiment may be the same components as the magnetostrictive rod 2, the coil 3 and the beam portion 73 of the first embodiment, respectively.

The connecting yoke 46 is connected with the proximal end portion 21 of the magnetostrictive rod 2 and a proximal end of the beam portion 73.

In the connecting yoke 46, two slits (upper slit and lower slit) 461, 462 extending in a width direction thereof are formed. The proximal end portion 21 of the magnetostrictive rod 2 is inserted into the lower slit 461 and the proximal end of the beam portion 73 is inserted into the upper slit 462. In this state, the proximal end portion 21 of the magnetostrictive rod 2 and the proximal end of the beam portion 73 are fixed to the connecting yoke 46 by using a pin.

The connecting yoke 46 is fixed to the support portion 47.

The support portion 47 has a plate-like shape. Almost in a center at a distal side of the support portion 47, a groove 471 is formed so as to pass through the support portion 47 in the width direction thereof. The connecting yoke 46 is inserted into and fixed to the groove 471.

When the power generator 1 of this embodiment is fixed to the vibrating body through the support portion 47, the magnetostrictive rod 2 is supported in a cantilevered state in which the proximal end of the magnetostrictive rod 2 serves as a fixed end and the distal end of the magnetostrictive rod 2 serves as a movable end.

The connecting yoke 56 is connected with the distal end portion 22 of the magnetostrictive rod 2 and a distal end of the beam portion 73.

In the connecting yoke 56, two slits (upper slit and lower slit) 561, 562 extending in a width direction thereof are formed. The distal end portion 22 of the magnetostrictive rod 2 is inserted into the lower slit 561 and the distal end of the beam portion 73 is inserted into the upper slit 562. In this state, the distal end portion 22 of the magnetostrictive rod 2 and the distal end of the beam portion 73 are fixed to the connecting yoke 56 by using a pin. In the power generator 1 of this embodiment, a distance between the slits 561, 562 of the connecting yoke 56 is smaller (shorter) than a distance between the slits 461, 462 of the connecting yoke 46. In such a configuration, the space between the magnetostrictive rod 2 and the beam portion 73 at the distal end of the magnetostrictive rod 2 is smaller than that at the proximal end of the magnetostrictive rod 2 in the side view of the power generator 1.

The connecting yoke 56 is fixed to the weight portion 57.

The weight portion 57 has a plate-like shape. Almost in a center at a proximal side of the weight portion 57, a groove 571 is formed so as to pass through the weight portion 57 in the width direction thereof. The connecting yoke 56 is inserted into and fixed to the groove 571.

The weight portion 57 serves as a weight for applying external force or vibration to the magnetostrictive rod 2. When the vibrating body vibrates, external force in the vertical direction or vibration in the vertical direction is applied to the weight portion 57. By applying the external force or the vibration to the magnetostrictive rod 2, the magnetostrictive rod 2 begins reciprocating motion in the vertical direction under the cantilevered state, in which the proximal end portion of the magnetostrictive rod 2 serves as the fixed end portion and the distal end portion of the magnetostrictive rod 2 serves as the movable end portion.

For example, a constituent material of the connecting yokes 46, 56, the support portion 47 and the weight portion 57 may be the same material as the constituent material of the first and second block bodies 4, 5 of the first embodiment.

The yoke 8 has a plate-like shape and is arranged in parallel with both the magnetostrictive rod 2 and the beam portion 73 with a predetermined space therebetween. For example, a constituent material of the yoke 8 may be the same material as the constituent material of the first and second block bodies 4, 5 of the first embodiment.

Each permanent magnet 6 has a cylindrical shape. For example, a constituent material of the permanent magnet 6 may be the same material as the constituent material of permanent magnet 6 of the first embodiment.

As shown in Fig. 14, the permanent magnet 6 provided between the connecting yoke 46 and the yoke 8 is arranged so that its south pole faces to the connecting yoke 46 and its north pole faces to the yoke 8. Further, the permanent magnet 6 provided between the connecting yoke 56 and the yoke 8 is arranged so that its south pole faces to the yoke 8 and its north pole faces to the connecting yoke 56. Due to this arrangement, it is possible to form a magnetic field loop circulating in a clockwise direction in the power generator 1.

In the power generator 1 of this embodiment, since the magnetostrictive rod 2 and the beam portion 73 are arranged in the thickness direction thereof (in the vertical direction of Fig. 14), the space for the coil 3 wound around magnetostrictive rod 2 is restricted due to the space between the magnetostrictive rod 2 and the beam portion 73. However, in the same manner as the power generator 1 of the first embodiment, the power generator 1 of this embodiment is configured so that the space between the magnetostrictive rod 2 and the beam portion 73 at the distal end of the magnetostrictive rod 2 is smaller than that at the proximal end of the magnetostrictive rod 2 in a side view thereof. With such a configuration, when the external force is applied to the weight portion 57 of the power generator 1, it is possible to smoothly displace the magnetostrictive rod 2 and the beam portion 73 in the vertical direction. As a result, it is possible to make variability of stress caused in the thickness direction of the magnetostrictive rod 2 small. As a result, it is possible to cause uniform stress in the magnetostrictive rod 2 to thereby improve the power generating efficiency of the power generator 1.

In this regard, the power generator of this embodiment may be configured so that the coil 3 is wound around the yoke 8 instead of winding the coil 3 around the magnetostrictive rod 2. Since the magnetic flux density in the yoke 8 is also similarly varied as the magnetic flux density in the magnetostrictive rod 2 due to the variation of magnetic flux density in the magnetostrictive rod 2, it is possible to generate a voltage in the coil 3 in the same manner as the power generator 1 having the configuration described above. Further, in such a configuration, by adjusting the width of the connecting yokes 46, 56 to become larger and/or by adjusting the thickness of each permanent magnet 6 to become larger, it is possible to make a space between the yoke 8 and each of the magnetostrictive rod 2 and the beam portion 73 larger. With such a configuration, it is possible to make the space for the coil 3 wound around the yoke 8 large in the same manner as the power generator 1 of the first embodiment. This makes it possible to further improve the power generating efficiency of the power generator 1

In this regard, for example, component members constituting the power generator 1 may be fixed or connected together by the fixing method or the connecting method such as press-fitting method using a pin, a welding method and a bonding method using an adhesive agent.

The power generator 1 according to the second embodiment can also provide the same functions/effects as the power generator 1 according to the first embodiment.

<Third embodiment>

Next, description will be given to a power generator according to a third embodiment.

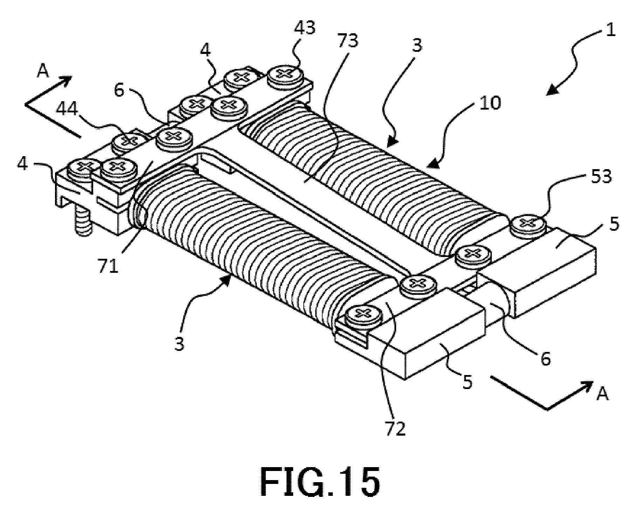

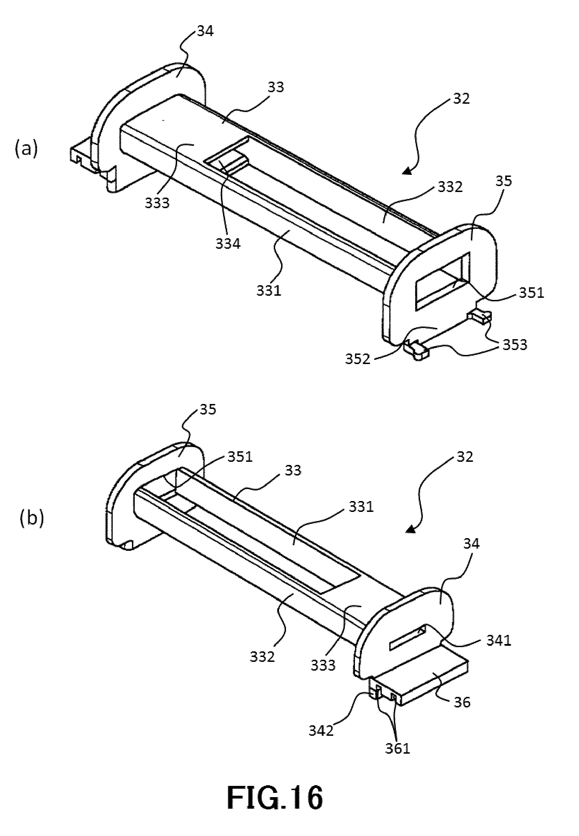

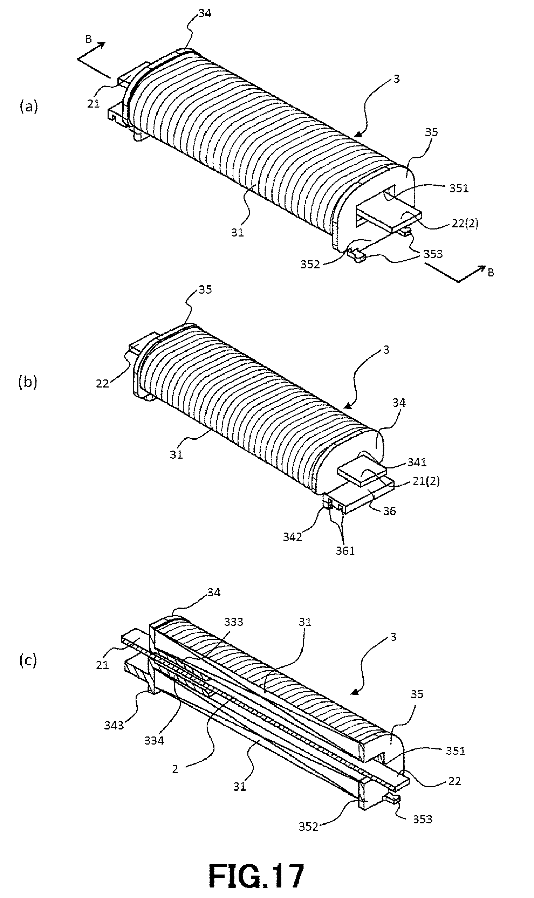

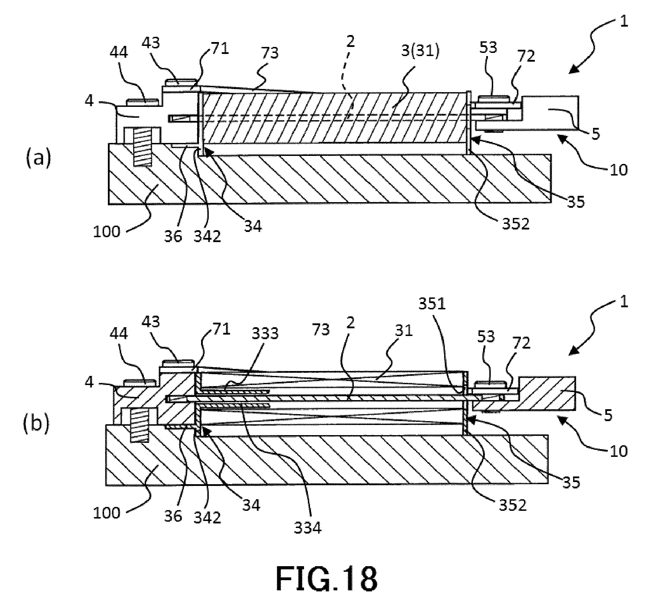

Fig. 15 is a perspective view showing a power generator according to a third embodiment of the present invention. Figs. 16(a) and 16(b) are perspective views showing the bobbin of the coil of the power generator shown in Fig. 15. Figs. 17(a) and 17(b) are perspective views showing the magnetostrictive rod and the coil of the power generator shown in Fig. 15. Fig. 17(c) is a cross-sectional perspective view of the magnetostrictive rod and the coil taken along a B-B line shown in Fig. 17(a). Fig. 18(a) is a side view explaining a state in which the power generator shown in Fig. 15 is fixedly attached to a vibrating body. Fig. 18(b) is a longitudinal cross-sectional view (taken along an A-A line shown in Fig. 15) showing the power generator shown in Fig. 15 fixedly attached to the vibrating body.

Hereinafter, an upper side in each of Figs. 15, 16(a), (b), 17(a), (b), (c) and 18(a), (b), (c) is referred to as "upper" or "upper side" and a lower side in each of Figs. 15, 16(a), (b), 17(a), (b), (c) and 18(a), (b), (c) is referred to as "lower" or "lower side". Further, a right front side of the paper in Fig. 15 and a right side in each of Figs. 18(a) and (b) are referred to as "distal side" and a left rear side of the paper in Fig. 15 and a left side in each of Figs. 18(a) and (b) are referred to as "proximal side".

In Fig. 16(a), a distal end of the bobbin is shown at a right front side of the paper. Further, in Fig. 16(b), a proximal end of the bobbin is shown at a right front side of the paper. Further, in Figs. 17(a) and (c), distal ends of the magnetostrictive rod and the coil are shown at a right front side of the paper. Further, in Fig. 17(b), proximal ends of the magnetostrictive rod and the coil are shown at a right front side of the paper.

Hereinafter, the power generator according to the third embodiment will be described by placing emphasis on the points differing from the power generators according to the first to the third embodiments, with the same matters being omitted from description.

A power generator 1 according to the third embodiment has the same configuration as the power generator 1 according to the first embodiment except that the configuration of the coil 3 is modified. Namely, in the power generator 1 of this embodiment, the coil 3 includes a bobbin 32 arranged around an outer peripheral portion of the magnetostrictive rod 2 so as to surround the magnetostrictive rod 2 and a wire 31 wound around the bobbin 32.

As shown in Figs. 16(a), (b), the bobbin 32 has a longitudinal main body 33 around which the wire 31 is wound, a first flange portion 34 connected with a proximal end of the main body 33 and a second flange portion 35 connected with a distal end of the main body 33. The bobbin 32 may be formed of the main body 33, the first flange portion 34 and the second flange portion 35 connected to each other with a welding method and the like, but it is preferred that these portions 33, 34 and 35 are integrally formed.

The main body 33 includes a pair of longitudinal side plate portions 331, 332, an upper plate portion 333 connecting upper ends of the side plate portions 331, 332 together at a proximal end side of the main body 33 and a lower plate portion 334 connecting lower ends of the side plate portions 331, 332 together at a proximal end side of the main body 33. Each of the side plate portions 331, 332, the upper plate portion 333 and the lower plate portion 334 has a plate-like shape.

The main body 33 has a rectangular parallelepiped portion defined by the side plate portions 331, 332, the upper plate portion 333 and the lower plate portion 334 at a proximal end side thereof. In this embodiment, the magnetostrictive rod 2 is inserted into an inside of the rectangular parallelepiped portion.

A distance (space) between the side plate portions 331, 332 is adjusted so as to become larger than the width of the magnetostrictive rod 2. The magnetostrictive rod 2 is arranged between the side plate portions 331, 332 in a state of being separated from the side plate portions 331, 332. Further, a distance (space) between the upper plate portion 333 and the lower plate portion 334 is substantially equal to the thickness of the magnetostrictive rod 2. The magnetostrictive rod 2 is inserted between the upper plate portion 333 and the lower plate portion 334 so that a part of the proximal end side of the magnetostrictive rod 2 is held therebetween (see Fig. 17(c)). Further, the wire 31 is wound around an outer peripheral portion of the main body 33.

The first flange portion 34 connected with the main body 33 (the side plate portions 331, 332, the upper plate portion 333 and the lower plate portion 334) is provided at the proximal end side of the main body 33 (see Fig. 16(b)).

The first flange portion 34 has a plate-like shape and is formed into a substantially elliptical shape. In the first flange portion 34, a slit 341 in which the magnetostrictive rod 2 is inserted is formed at a position where the first flange portion 34 is connected with the main body 33. The slit 341 has the substantially same shape as the cross-sectional shape of the magnetostrictive rod 2.

Further, a lower end portion 342 of the first flange portion 34 is configured so as to make contact with the vibrating body 100 when the power generator 1 is fixedly attached to the vibrating body 100.

Further, the first flange portion 34 has a protruding portion 36 protruding toward the proximal end side and the protruding portion 36 is provided in a lower side of the slit 341. In the power generator 1 of this embodiment, the bobbin 32 is arranged around the magnetostrictive rod 2 so that an upper part above the protruding portion 36 of the first flange portion 34 makes contact with a distal end of the first block body 4 (the tall block body 41) and the protruding portion 36 makes contact with a lower surface of the first block body 4. In a lower surface of the protruding portion 36, two grooves 361 are formed so as to extend along a width direction of the protruding portion 36. Not shown in the drawings, in the case where two protruding portions corresponding to the two grooves 361 are formed in the vibrating body 100 to which the power generator 1 is fixedly attached, by engaging the two protruding portions of the vibrating body 100 with the two grooves 361 of the power generator 1 (the protruding portion 36), it is possible to easily arrange the power generator 1 at a prescribed position of the vibrating body 100. Namely, this makes it possible to easily position the power generator 1 to the vibrating body 100.

The second flange portion 35 connected with the main body 33 (the side plate portions 331, 332) is provided at the distal end side of the main body 33 (see Fig. 16(a)).

The second flange portion 35 has a plate-like shape and is formed into a substantially elliptical shape. In the second flange portion 35, an opening 351 in which the magnetostrictive rod 2 is inserted is formed at a position where the second flange portion 35 is connected with the main body 33. The opening 351 has a substantially quadrangular shape. A width of the opening 351 is substantially equal to the distance between the side plate portions 331, 332. Further, a distance from an upper end to a lower end of the opening 351 is adjusted so as to be substantially equal to a length in a width direction (a short direction) of each of the side plate portions 331, 332.

A lower end portion 352 of the second flange portion 35 is configured so as to make contact with the vibrating body 100 when the power generator 1 is fixedly attached to the vibrating body 100. Further, two protruding portions 353 protruding toward the distal end side are respectively provided in both end sides of a width direction of the lower end portion 352. The lower end portion 352 and the two protruding portions 353 with the lower end portion 342 of the first flange portion 34 support the bobbin 32 with respect to the vibrating body 100. The second flange portion 35 is separated from the second block body 5 in a state that the bobbin 32 is attached to the magnetostrictive rod 2.

As shown in Fig. 18(b), in the power generator 1 of this embodiment, a gap is formed between the magnetostrictive rod 2 and the bobbin 32 (or the wire 31) in the displacement direction (the vertical direction in Fig. 18(b)) of the magnetostrictive rod 2 from a vicinity of center of the bobbin 32 to the distal end of the power generator 1. The gap is formed so as to have a size so that the magnetostrictive rod 2 and the bobbin 32 (or the wire 31) do not mutually interfere with each other when the magnetostrictive rod 2 is displaced by vibration of the vibrating body 100. Namely, the gap is formed so that the size of the gap becomes larger than amplitude of vibration of the magnetostrictive rod 2. Thus, it is possible to vibrate the magnetostrictive rod 2 without the magnetostrictive rod 2 making contact with the bobbin 32 (or the wire 31). In such a configuration, it is possible to prevent occurrence of energy loss caused by friction between the magnetostrictive rod 2 and coil 3.

Further, in the power generator 1 of this embodiment, when the magnetostrictive rod 2 and the beam portion 73 are deformed, the coil 3 (the wire 31 and the bobbin 32) is not deformed with the deformation of the magnetostrictive rod 2 and the beam portion 73. Generally, an amount of energy loss caused by deformation of a wire and a bobbin forming a coil is large. Namely, each of the wire and the bobbin has a high loss coefficient. Thus, in the power generator 1 of this embodiment, it is possible to prevent occurrence of energy loss (structural attenuation) caused by deformation of the wire 31 and the bobbin 32 each having the high loss coefficient. Further, in the power generator 1 of this embodiment, the coil 3 having large mass is not deformed due to the deformation of the magnetostrictive rod 2. Namely, mass of the coil 3 is not included in total mass of a vibration system vibrating the magnetostrictive rod 2. Therefore, in the power generator 1 of this embodiment, it is possible to prevent a vibration frequency of the magnetostrictive rod 2 (the vibration system) from being lowered in comparison with a power generator in which a coil is deformed with a magnetostrictive rod. This makes it possible to prevent the amount of variation of the magnetic flux density in the magnetostrictive rod 2 per unit time (a change gradient of a magnetic flux density) from being reduced, thereby improving power generating efficiency in the power generator 1.

With such a configuration, it is possible to prevent the occurrence of energy loss caused by friction between the magnetostrictive rod 2 and coil 3 and the occurrence of energy loss caused by deformation of the coil 3 having the high loss coefficient. Further, it is possible to prevent a vibration frequency of the magnetostrictive rod 2 (the vibration system) from being lowered due to the deformation of the coil 3 having the large mass. Therefore, in the power generator 1 of this embodiment, the vibration of the vibrating portion 100 is effectively utilized to deform the magnetostrictive rod 2, thereby improving power generating efficiency in the power generator 1.

Further, by changing the length in the width direction (a short direction) of each of the side plate portions 331, 332 and thereby adjusting the distance from the upper end to the lower end of the opening 351 as the length of each of the side plate portions 331, 332, it is possible to freely adjust the size of the gap between the magnetostrictive rod 2 and the bobbin 32 (or the wire 31).

For example, a constituent material of the bobbin 32 may be the same material as the constituent material of the connecting member 7.

The power generator 1 according to the third embodiment can also provide the same functions/effects as the power generators 1 according to the first and second embodiments.

Although the power generator of the present invention has been described with reference to the accompanying drawings, the present invention is not limited thereto. In the power generator, the configuration of each component may be possibly replaced by other arbitrary configurations having equivalent functions. It may be also possible to add other optional components to the present invention.

For example, it may be also possible to combine the configurations according to the first embodiment to the third embodiments of the present invention in an appropriate manner.

Further, one of the two permanent magnets may be omitted from the power generator and one or both of the two permanent magnets may be replaced by an electromagnet. Furthermore, the power generator of the present invention can have another configuration in which the permanent magnets are omitted from the power generator and the power generation of the power generator may be achieved by utilizing an external magnetic field.

Further, although both the magnetostrictive rod and the beam portion have the rectangular cross-sectional shape in each of the embodiments, the present invention is not limited thereto. Examples of the cross-sectional shapes of the magnetostrictive rod and the reinforcing rod include a circular shape, an elliptical shape and a polygonal shape such as a triangular shape, a square shape and a hexagonal.

Further, although the permanent magnet has the cylindrical shape in each of the embodiments, the present invention is not limited thereto. Examples of the shape of the permanent magnet include a prismatic shape, a plate shape and a triangular prismatic.

## EXAMPLES

Hereinafter, the present invention will be described in detail with reference to specific examples, but is not limited to the descriptions of these examples.

In a power generator 1 of each Example described below, a length of a magnetostrictive rod 2 other than both end portions 21, 22 thereof was 21.65 mm, a width of the magnetostrictive rod 2 was 3 mm, a thickness of the magnetostrictive rod 2 was 0.5 mm, a width of the beam portion 73 was 3 mm and a thickness of the beam portion 73 was 0.5 mm.

(Example 1)

The power generator 1 having a configuration shown in Fig. 1 was prepared. In the power generator 1, by setting the space between the magnetostrictive rods 2, 2 and the beam portion 73 at the proximal and distal ends of the power generator 1 to 2.0 mm, 0 mm, respectively, an angle between the magnetostrictive rod 2 and the beam portion 73 in the side view of the power generator 1 (a taper angle) was adjusted to about 2.7°.

(Example 2)

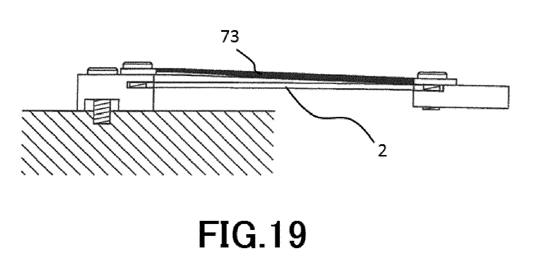

A power generator 1 having a configuration shown in Fig. 19 was prepared. In the power generator 1, by setting the space between the magnetostrictive rods 2, 2 and the beam portion 73 at the proximal and distal ends of the power generator 1 to 1.0 mm, 0 mm, respectively, an angle between the magnetostrictive rod 2 and the beam portion 73 in the side view of the power generator 1 (a taper angle) was adjusted to about 1°.

(Comparative Example)

The power generator 1 having a configuration shown in Fig. 11 was prepared. In this regard, the space between the magnetostrictive rods 2, 2 and the beam portion 73 (a distance between the upper surface of each magnetostrictive rod 2 and the lower surface of the beam portion 73 in the side view of the power generator 1) was 2.0 mm.

(Evaluation of stress distribution)

When external force was applied to the distal end of the power generator 1 (the second block body 5) of each Example in a downward direction thereof, stresses caused in the magnetostrictive rod 2 in the thickness direction and in the longitudinal direction were measured. In this regard, an amount of the external force was 20 N.

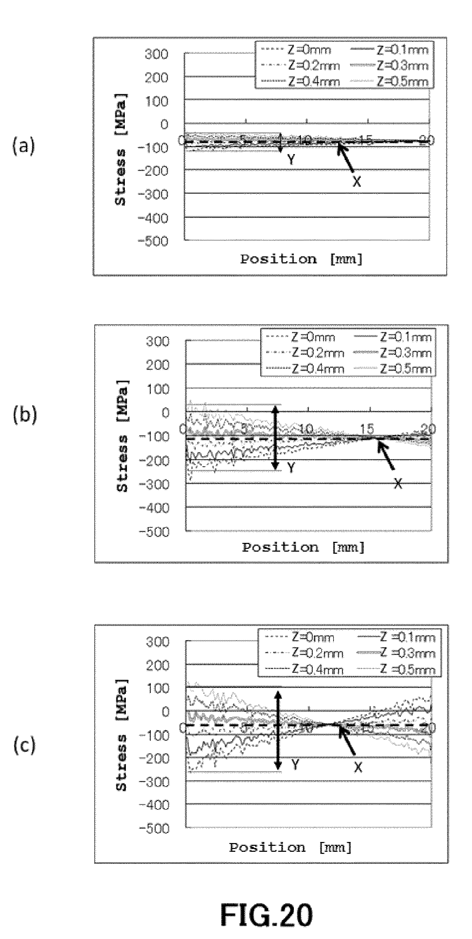

Figs. 20(a) to 20(C) are graphs respectively illustrating stress distribution caused in the magnetostrictive rod 2 of the power generator 1 of Examples 1 and 2 and Comparative Example along the longitudinal direction thereof at each region of the thickness direction thereof when external force was applied thereto. In these graphs, the stress having a positive value is an extension stress and the stress having a negative value is a contraction stress.

The stress distribution caused in each magnetostrictive rod 2 at the upper surface (Z=0), a region separated from the upper surface by 0.1 mm (Z=0.1), a region separated from the upper surface by 0.2 mm (Z=0.2), a region separated from the upper surface by 0.3 mm (Z=0.3), a region separated from the upper surface by 0.4 mm (Z=0.4) and a region separated from the upper surface by 0.5 mm (that is, the lower surface, Z=0.5) along the thickness direction as well as the longitudinal direction thereof was measured (see Figs. 20(a) to 20(c)). Further, based on the measurement result of the stress distribution, an average value of the stress caused in the whole of each magnetostrictive rod 2 (an average of stress "X" [MPa]), a difference between maximum and minimum values of the stress caused in each magnetostrictive rod 2 (a difference of stress "Y" [MPa]) and a value of Y/X were calculated. In this regard, variability of stress caused in the thickness direction of each magnetostrictive rod 2 was evaluated based on the value of Y/X. The evaluation results obtained as described above are shown in Table 1.

[Table 1]

|  | Example 1 | Example 2 | Comparative Example |
|---|---|---|---|
| Average of stress (X) [MPa] | 75 | 110 | 62 |
| Difference of stress (Y) [MPa] | 68 | 242 | 327 |
| Y/X | 0.9 | 2.2 | 5.3 |

As shown in Table 1, by comparing the results of Examples 1 and 2 and Comparative Example, it was found that by forming the tapered beams configuration of the magnetostrictive rods 2, 2 and the beam portion 73, the variability of stress caused in the thickness direction of the magnetostrictive rod 2 became small.

Further, by comparing the results of Examples 1 and 2, it was found that the stress (the average of stress) caused in the magnetostrictive rod 2 of the power generator 1 in which the space between the magnetostrictive rods 2, 2 and the beam portion 73 was smaller became larger.

From the above results, it has been found that by forming the tapered beams configuration of the magnetostrictive rods 2, 2 and the beam portion 73, the variability of stress caused in the thickness direction of the magnetostrictive rod 2 became small. Further, it has been found that by making the space between the magnetostrictive rods 2, 2 and the beam portion 73 small, the stress caused in the magnetostrictive rod 2 became large. Therefore, it has been confirmed that in the power generator 1 of Example 2 in which the space between the magnetostrictive rods 2, 2 and the beam portion 73 is small and the magnetostrictive rods 2, 2 and the beam portion 73 form the tapered beams configuration, the variability of stress caused in the thickness direction of the magnetostrictive rod 2 became small while the stress (the average of stress) caused in the magnetostrictive rod 2 became large.

Further, it has been found that the power generating efficiency of each power generator 1 of Examples 1 and 2 having the tapered beam structure was higher than that of each power generator 1 of Comparative Example having the parallel beams configuration, in particular, the power generating efficiency of the power generator 1 of Example 2 was higher than that of each power generator 1 of Example 1 and Comparative Example.

## INDUSTRIAL APPLICABILITY

According to the present invention, the space between the magnetostrictive rod and the beam portion at the other end of the magnetostrictive rod is smaller than that at the one end of the magnetostrictive rod in a side view of the power generator. In such a configuration, a stiffness in a displacement direction of a pair of opposed beams formed from the magnetostrictive rod and the beam portion becomes gradually lower from a proximal end thereof toward a distal end thereof. With such a configuration, when external force is applied to the distal end of the magnetostrictive rod, it is possible to smoothly displace the magnetostrictive rod and the beam portion in the displacement direction. Therefore, it is possible to make variability of stress caused in the thickness direction of the magnetostrictive rod small. As a result, it is possible to cause uniform stress in the magnetostrictive rod to thereby improve the power generating efficiency of the power generator. For the reasons stated above, the present invention is industrially applicable.

**Claims**

1.   A power generator comprising:

at least one magnetostrictive rod through which lines of magnetic force pass in an axial direction thereof, the magnetostrictive rod formed of a magnetostrictive material and having one end and the other end;
a beam portion having a function of causing stress in the magnetostrictive rod; and
a coil provided so that the lines of magnetic force pass inside the coil in an axial direction of the coil whereby a voltage is generated due to variation of density of the lines of magnetic force,
wherein the power generator is configured so that the density of the lines of magnetic force varies when the other end of the magnetostrictive rod is relatively displaced toward a direction substantially perpendicular to an axial direction of the magnetostrictive rod with respect to the one end of the magnetostrictive rod to expand or contract the magnetostrictive rod, and
wherein a space between the magnetostrictive rod and the beam portion at the other end of the magnetostrictive rod is smaller than that at the one end of the magnetostrictive rod in a side view of the power generator.

2.   The power generator as claimed in claim 1, wherein an angle between the magnetostrictive rod and the beam portion in a side view of the power generator is in the range of 0.5 to 10°.

3.   The power generator as claimed in claim 1 or 2, wherein the beam portion is formed of a non-magnetic material.

4.   The power generator as claimed in any one of claims 1 to 3, wherein the magnetostrictive rod and the beam portion are arranged so as not to be overlapped with each other in a side view of the power generator.

5.   The power generator as claimed in any one of claims 1 to 4, wherein the at least one magnetostrictive rod comprises two or more magnetostrictive rods arranged in parallel with each other, and
wherein the two or more magnetostrictive rods and the beam portion are arranged so as not to be overlapped with each other in a planar view of the power generator.

6.   The power generator as claimed in claim 5, wherein the beam portion is arranged between the magnetostrictive rods in a planar view of the power generator.

7.   The power generator as claimed in claim 5 or 6, wherein the coil comprises two or more coils provided around the magnetostrictive rods, respectively, and
wherein each coil and the beam portion are arranged so as not to be overlapped with each other in a planar view of the power generator.

8.   The power generator as claimed in any one of claims 1 to 7, wherein each coil includes a bobbin arranged around an outer peripheral portion of the magnetostrictive rod so as to surround the magnetostrictive rod and a wire wound around the bobbin, and
wherein a gap is formed between the magnetostrictive rod and the bobbin on at least a side of the other end of the magnetostrictive rod.

9. The power generator as claimed in claim 8, wherein a displacement of the other end of each magnetostrictive rod is caused by applying vibration to the magnetostrictive rod, and
wherein the gap is formed so as to have a size so that the bobbin and the magnetostrictive rod do not mutually interfere while the magnetostrictive rod is vibrated.

10. The power generator as claimed in any one of claims 5 to 9, wherein a total number of the magnetostrictive rods and the beam portion is an odd number.

11. The power generator as claimed in any one of claims 5 to 10, further comprising at least one permanent magnet arranged so that a magnetization direction thereof is directed to an arrangement direction of the magnetostrictive rods, and
wherein the permanent magnet is arranged at least between the one ends of the magnetostrictive rods or between the other ends of the magnetostrictive rods.

12. The power generator as claimed in any one of claims 1 to 11, wherein when a spring constant of the beam portion is defined as "A" [N/m], a number of the beam portion is defined as "X" [piece], a spring constant of the magnetostrictive rod is defined as "B" [N/m], and a number of the magnetostrictive rod is defined as "Y" [piece], a value of "A $\times$ X" and a value of "B $\times$ Y" are substantially equal to each other.

13. The power generator as claimed in any one of claims 1 to 12, wherein a Young's modulus of a constituent material of the beam portion is in the range of 80 to 200 GPa, and a Young's modulus of the magnetostrictive material is in the range of 30 to 100 GPa.

14. The power generator as claimed in any one of claims 1 to 13, wherein the beam portion causes extension stress or contraction stress in the magnetostrictive rod in a natural state thereof.

15. The power generator as claimed in any one of claims 1 to 14, wherein the coil is provided around the magnetostrictive rod.

16. The power generator as claimed in any one of claims 1 to 15, further comprising at least one permanent magnet arranged so that a magnetization direction thereof is directed to a substantially orthogonal direction with respect to an axial direction of the magnetostrictive rod.

FIG.1

# FIG.2

FIG.3

FIG.4

FIG.5

FIG.6

FIG.7

FIG.8

FIG.9

FIG.10

# FIG.11

(a)

73

2

(b)

73

2

# FIG.12

FIG.13

FIG.14

FIG.15

FIG.16

FIG.17

FIG.18

FIG.19

FIG.20

## INTERNATIONAL SEARCH REPORT

| International application No. |
|---|
| PCT/JP2014/058592 |

A. CLASSIFICATION OF SUBJECT MATTER
*H02N2/00(2006.01)i*

According to International Patent Classification (IPC) or to both national classification and IPC

B. FIELDS SEARCHED

Minimum documentation searched (classification system followed by classification symbols)
H02N2/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2011/158473 A1 (National University Corporation Kanazawa University), 22 December 2011 (22.12.2011), paragraphs [0152] to [0157]; fig. 18A to 18C & JP 4905820 B2 & US 2013/0140919 A1 & EP 2573931 A1 & CN 102986129 A | 1-16 |
| A | JP 2012-161238 A (Nikon Corp.), 23 August 2012 (23.08.2012), entire text; all drawings & US 2013/0241211 A1 & WO 2012/096289 A1 | 1-16 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 05 June, 2014 (05.06.14) | 17 June, 2014 (17.06.14) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
| --- |
| PCT/JP2014/058592 |

C (Continuation).   DOCUMENTS CONSIDERED TO BE RELEVANT

| Category* | Citation of document, with indication, where appropriate, of the relevant passages | Relevant to claim No. |
| --- | --- | --- |
| E,X | JP 2014-96924 A  (Toyo Tire and Rubber Co., Ltd.), 22 May 2014 (22.05.2014), paragraphs [0081] to [0098], [0129]; fig. 12 to 13 (Family: none) | 1,4-5,7,10, 14-16 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011158473 A